(19) Europäisches Patentamt
European Patent Office
Office européen des brevets

(11) **EP 4 730 660 A1**

(12) **EUROPEAN PATENT APPLICATION**
published in accordance with Art. 153(4) EPC

(43) Date of publication:
**22.04.2026 Bulletin 2026/17**

(21) Application number: **24843426.8**

(22) Date of filing: **11.07.2024**

(51) International Patent Classification (IPC):
**H03M 13/11** (2006.01)   **H03M 13/00** (2006.01)

(52) Cooperative Patent Classification (CPC):
**H03M 13/00; H03M 13/11**

(86) International application number:
**PCT/KR2024/009954**

(87) International publication number:
**WO 2025/018708 (23.01.2025 Gazette 2025/04)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **14.07.2023 KR 20230091893
30.08.2023 KR 20230114853**

(71) Applicant: **Samsung Electronics Co., Ltd.
Suwon-si, Gyeonggi-do 16677 (KR)**

(72) Inventor: **MYUNG, Seho
Suwon-si, Gyeonggi-do 16677 (KR)**

(74) Representative: **Nederlandsch Octrooibureau
P.O. Box 29720
2502 LS The Hague (NL)**

(54) **METHOD AND DEVICE FOR ENCODING AND DECODING DATA IN COMMUNICATION OR BROADCASTING SYSTEM**

(57) The disclosure relates to a 5G or 6G communication system supporting a higher data transmission rate than the previous 4G communication system, such as LTE.

FIG. 10

**Description**

<u>CROSS-REFERENCE TO RELATED APPLICATIONS</u>

This application is a continuation of International Application No. PCT/KR2024/009954 designating the United States, filed on July 11, 2024, in the Korean Intellectual Property Receiving Office and claiming priority to Korean Patent Application Nos. 10-2023-0091893, filed on July 14, 2023, and 10-2023-0114853, filed on August 30, 2023, in the Korean Intellectual Property Office, the disclosures of each of which are incorporated by reference herein in their entireties.

<u>BACKGROUND</u>

<u>Field</u>

The disclosure relates to a method and device for encoding and decoding data in a communication or broadcasting system.

<u>Description of Related Art</u>

Considering the development of wireless communication from generation to generation, the technologies have been developed mainly for services targeting humans, such as voice calls, multimedia services, and data services. Following the commercialization of 5G (5th-generation) communication systems, it is expected that the number of connected devices will exponentially grow. Increasingly, these will be connected to communication networks. Examples of connected things may include vehicles, robots, drones, home appliances, displays, smart sensors connected to various infrastructures, construction machines, and factory equipment. Mobile devices are expected to evolve in various form-factors, such as augmented reality glasses, virtual reality headsets, and hologram devices. In order to provide various services by connecting hundreds of billions of devices and things in the 6G (6th-generation) era, there have been ongoing efforts to develop improved 6G communication systems. For these reasons, 6G communication systems are referred to as beyond-5G systems.

6G communication systems, which are expected to be commercialized around 2030, will have a peak data rate of tera (1,000 giga)-level bps and a radio latency less than 100$\mu$sec, and thus will be 50 times as fast as 5G communication systems and have the 1/10 radio latency thereof.

In order to accomplish such a high data rate and an ultra-low latency, it has been considered to implement 6G communication systems in a terahertz band (for example, 95GHz to 3THz bands). It is expected that, due to severer path loss and atmospheric absorption in the terahertz bands than those in mmWave bands introduced in 5G, technologies capable of securing the signal transmission distance (that is, coverage) will become more crucial. It is necessary to develop, as major technologies for securing the coverage, radio frequency (RF) elements, antennas, novel waveforms having a better coverage than orthogonal frequency division multiplexing (OFDM), beamforming and massive multiple input multiple output (MIMO), full dimensional MIMO (FD-MIMO), array antennas, and multiantenna transmission technologies such as large-scale antennas. In addition, there has been ongoing discussion on new technologies for improving the coverage of terahertz-band signals, such as metamaterial-based lenses and antennas, orbital angular momentum (OAM), and reconfigurable intelligent surface (RIS).

Moreover, in order to improve the spectral efficiency and the overall network performances, the following technologies have been developed for 6G communication systems: a full-duplex technology for enabling an uplink transmission and a downlink transmission to simultaneously use the same frequency resource at the same time; a network technology for utilizing satellites, high-altitude platform stations (HAPS), and the like in an integrated manner; an improved network structure for supporting mobile base stations and the like and enabling network operation optimization and automation and the like; a dynamic spectrum sharing technology via collison avoidance based on a prediction of spectrum usage; an use of artificial intelligence (AI) in wireless communication for improvement of overall network operation by utilizing AI from a designing phase for developing 6G and internalizing end-to-end AI support functions; and a next-generation distributed computing technology for overcoming the limit of UE computing ability through reachable super-high-performance communication and computing resources (such as mobile edge computing (MEC), clouds, and the like) over the network. In addition, through designing new protocols to be used in 6G communication systems, developing mecahnisms for implementing a hardware-based security environment and safe use of data, and developing technologies for maintaining privacy, attempts to strengthen the connectivity between devices, optimize the network, promote softwarization of network entities, and increase the openness of wireless communications are continuing.

It is expected that research and development of 6G communication systems in hyper-connectivity, including person to machine (P2M) as well as machine to machine (M2M), will allow the next hyper-connected experience. Particularly, it is expected that services such as truly immersive extended reality (XR), high-fidelity mobile hologram, and digital replica could be provided through 6G communication systems. In addition, services such as remote surgery for security and reliability enhancement, industrial automation, and emergency response will be provided through the 6G communication system such that the technologies could be applied in various fields such as industry, medical care, automobiles, and home appliances.

## SUMMARY

Embodiments of the disclosure provide algebraic properties that a parity-check matrix of an LDPC code for reducing decoding latency and encoding complexity should satisfy. Further, embodiments of the disclosure provide an efficient encoding and decoding method and device using an LDPC code having the above algebraic properties.

Embodiments of the disclosure provide algebraic properties that a parity-check matrix of an LDPC code should satisfy in order to reduce a block error rate (BLER). Embodiments of the disclosure provide an efficient encoding and decoding method and device using an LDPC code having the algebraic properties.

Embodiments of the disclosure provide algebraic properties that a parity-check matrix of an LDPC code should satisfy by appropriately combining the above algebraic properties in order to simultaneously reduce decoding latency, encoding complexity, and BLER. Embodiments of the disclosure provide an efficient encoding and decoding method and device using an LDPC code having the combined algebraic properties.

According to an example embodiment of the disclosure, a method of transmitting data of a base station or a terminal in a communication system may include: low density parity check (LDPC) encoding data based on a base matrix and/or a parity-check matrix, applying rate matching to the encoded data, modulating the rate-matched encoded data, and transmitting the modulated signal through a transmission device, wherein the base matrix, the parity-check matrix, or a weight matrix corresponding thereto satisfies a specific algebraic condition.

According to an example embodiment of the disclosure, a method of receiving data by a base station or a terminal in a communication system may include: receiving a modulated signal through a receiving device, performing demodulation to determine values for decoding based on the received signal, performing LDPC decoding based on the determined values and a base matrix and/or a parity-check matrix, applying rate dematching to the LDPC decoded result, and determining data from the rate dematched result, wherein the base matrix, the parity-check matrix, or a weight matrix corresponding thereto satisfies a specific algebraic condition.

According to the various example embodiments of the disclosure, by providing algebraic properties of a parity-check matrix for reducing latency and BLER, LDPC codes can be effectively supported for variable lengths and variable rates.

## BRIEF DESCRIPTION OF THE DRAWINGS

The above and other aspects, features and advantages of certain embodiments of the present disclosure will be more apparent from the following detailed description, taken in conjunction with the accompanying drawings, in which:

FIG. 1 is a diagram illustrating an example systematic LDPC codeword structure according to various embodiments.
FIG. 2 is a diagram illustrating an example method of representing a graph of an LDPC code according to various embodiments.
FIG. 3A is a diagram illustrating example cycle characteristics of a QC-LDPC code according to various embodiments.
FIG. 3B is a diagram illustrating example cycle characteristics of a QC-LDPC code according to various embodiments.
FIG. 4 is a diagram illustrating an example transport block structure according to various embodiments.
FIG. 5 is a flowchart illustrating an example LDPC encoding process according to various embodiments.
FIG. 6 is a flowchart illustrating an example LDPC decoding process according to various embodiments.
FIG. 7 is a block diagram illustrating an example configuration of a transmitting device according to various embodiments.
FIG. 8 is a block diagram illustrating an example configuration of a receiving device according to various embodiments.
FIG. 9 is a block diagram illustrating an example configuration of an LDPC decoding unit according to various embodiments.
FIG. 10 is a diagram illustrating an example structure of a parity-check matrix of an LDPC code according to various embodiments.
FIGS. 11A and 11B are diagrams illustrating example parity check matrices for LDPC codes satisfying characteristics according to various embodiments.

## DETAILED DESCRIPTION

Hereinafter, various example embodiments of the disclosure will be described in greater detail with reference to the accompanying drawings. In describing the disclosure, in the case where it is determined that a detailed description of a related well-known function or configuration may unnecessarily obscure the gist of the disclosure, a detailed description thereof may be omitted. Terms described below are terms defined in consideration of functions in the disclosure, which may vary according to intentions or customs of users and operators. Therefore, the definition should be made based on the content throughout this disclosure.

The disclosure may be applied, with slight modifications, to other systems having similar technical backgrounds without departing from the spirit or scope of the disclosure, and such modifications may be readily implemented by those skilled in the art. For reference, although the term "communication system" generally encompasses a broadcasting system, in the disclosure, in the case where a broadcasting service is a primary service of a communication system, it may be more clearly referred to as a broadcasting system.

Advantages and features of various embodiments of the disclosure, and a method of achieving them will become apparent with reference to the various example embodiments described below in detail in conjunction with the accompanying drawings. However, the disclosure is not limited to the various embodiments disclosed below, but may be implemented in various different forms. Like reference numerals refer to like components throughout the disclosure.

Low density parity check (LDPC) codes, first introduced by Gallager in the 1960s, were forgotten for a long time due to their complexity, which made them difficult to implement with the technology available at the time. However, in 1993, the turbo codes proposed by Berrou, Glavieux, and Thitimajshima demonstrated performance close to the Shannon channel capacity, which prompted extensive analysis of the performance and characteristics of turbo codes and led to significant research into iterative decoding and graph-based channel coding. This led to a restudy of LDPC codes in the late 1990s, and it was revealed that when decoding is performed applying iterative decoding based on the sum-product algorithm on Tanner graphs corresponding to the LDPC codes, the LDPC codes also achieve performance close to the Shannon channel capacity.

LDPC codes may be generally defined as a parity-check matrix and may be represented using a bipartite graph, commonly referred to as a Tanner graph. In general, LDPC codes are a type of parity-check code, and they are referred to as 'low-density' parity-check codes because, in the parity-check matrix for very long codes, the ratio (e.g., density) of the number of 1s is very low. Therefore, in the disclosure, for convenience, techniques based on LDPC codes may be easily extended to general parity-check matrix codes.

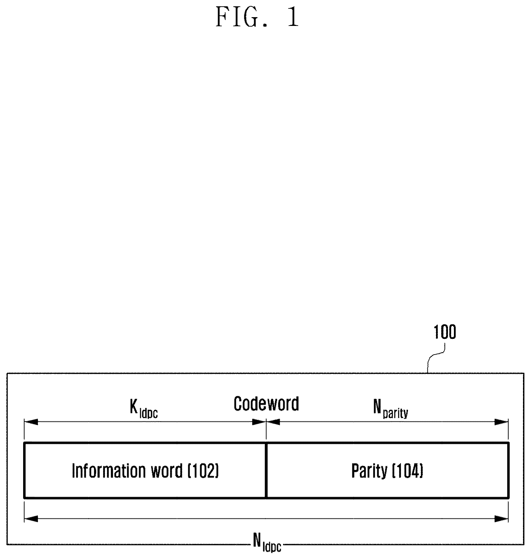

FIG. 1 is a diagram illustrating an example systematic LDPC codeword structure according to various embodiments.

With reference to FIG. 1, a device in which LDPC encoding is performed receives an information word 102 including $K_{ldpc}$ bits or symbols and performs encoding to generate a codeword 100 including $N_{ldpc}$ bits or symbols. Hereinafter, for convenience of description, it is assumed that an information word 102 including $K_{ldpc}$ bits is received and that a codeword 100 including $N_{ldpc}$ bits is generated. For example, when an information word $\underline{i} = (i_0, i_1, i_2, ..., i_{K_{ldpc}-1})$ 102 having $K_{ldpc}$ input bits is LDPC encoded, a codeword $\underline{c} = (c_0, c_1, c_2, ..., c_{N_{ldpc}-1})$ 100 is generated. For example, the information word and the codeword are bit sequences including multiple bits, and the information bits and codeword bits may refer, for example, to the respective bits of the information word and the codeword. In the case where the LDPC encoding bits include information words such as:

$$\underline{c} = \left( c_0, c_1, c_2, ..., c_{N_{ldpc}-1} \right) = \left( \underline{i}, \underline{w} \right) =$$

$$(i_0, i_1, i_2, ..., i_{K_{ldpc}-1}, w_0, w_1, w_2, ..., w_{N_{ldpc}-K_{ldpc}-1}),$$

it is referred to as a systematic code. Here, $\underline{w} = [w_0\ w_1\ w_2\ ...\ w_{N_{ldpc}-K_{ldpc}-1}]$ is a parity bit 104, and the number $N_{parity}$ of parity bits may be represented as $N_{parity} = N_{ldpc} - K_{ldpc}$.

The LDPC code is a type of linear block code and includes a process of determining a codeword that satisfies conditions in Equation 1.

[Equation 1]

$$H \cdot \underline{c}^T = \begin{bmatrix} \mathbf{h}_0 & \mathbf{h}_1 & \mathbf{h}_2 & ... & \mathbf{h}_{N_{ldpc}-1} \end{bmatrix} \cdot \underline{c}^T = \sum_{i=0}^{N_{ldpc}-1} c_i \cdot \mathbf{h}_i = \underline{0}$$

where $\underline{c} = [c_0\ c_1\ c_2\ \cdots\ c_{N_{ldpc}-1}]$.

In Equation 1, H is a parity-check matrix, c is a codeword, $c_i$ is an i-th bit of the codeword, and $N_{ldpc}$ is an LDPC codeword length, and $\mathbf{h}_i$ is an i-th column of a parity-check matrix H.

The parity-check matrix H may include $N_{ldpc}$ columns, which corresponds to the number of bits in the LDPC codeword. Because Equation 1 indicates that the sum of products of the i-th column $\mathbf{h}_i$ of the parity-check matrix and the i-th codeword bit $c_i$ is '0', the i-th column $\mathbf{h}_i$ is related to the i-th codeword bit $c_i$.

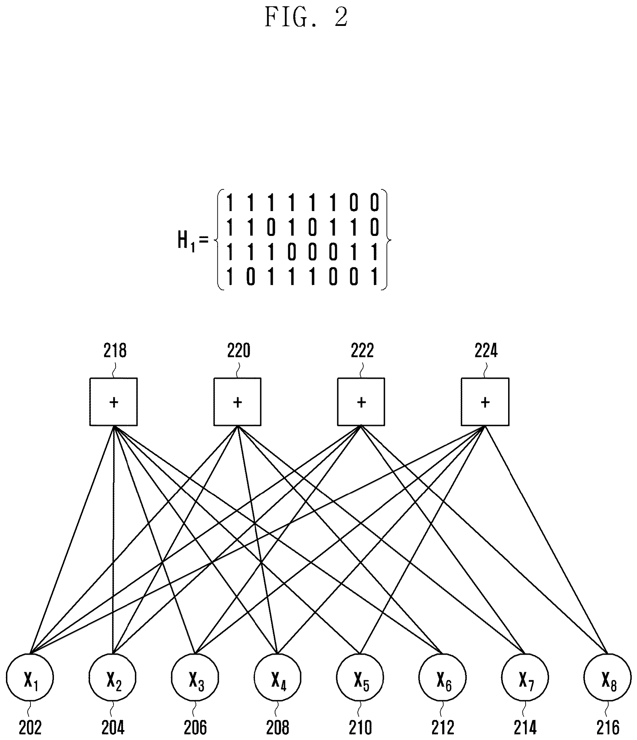

FIG. 2 is a diagram illustrating an example method of representing a graph of an LDPC code according to various embodiments.

With reference to FIG. 2, an example method of representing a graph of an LDPC code will be described in greater detail.

FIG. 2 is a diagram illustrating an example of a parity-check matrix $H_1$ of an LDPC code having 4 rows and 8 columns and a Tanner graph thereof. With reference to FIG. 2, because the parity-check matrix $H_1$ has 8 columns, a codeword of a length 8 is generated, and a code generated through $H_1$ may refer, for example, to an LDPC code, and each column corresponds to 8 encoded bits.

With reference to FIG. 2, a Tanner graph of an LDPC code that encodes and decodes based on a parity-check matrix $H_1$ includes eight variable nodes, that is, $x_1(202)$, $x_2(204)$, $x_3(206)$, $x_4(208)$, $x_5(210)$, $x_6(212)$, $x_7(214)$, $x_8(216)$, and four check nodes 218, 220, 222, and 224. An i-th column and a j-th row of the parity-check matrix $H_1$ of the LDPC code correspond to a variable node $x_i$ and a j-th check node, respectively. The meaning of a value of 1, that is, a non-zero value, at the point where the i-th column and the j-th row of the parity-check matrix $H_1$ of the LDPC code intersect may refer to there being an edge connecting a variable node $x_i$ and a j-th check node on the Tanner graph, as illustrated in FIG. 2.

In the Tanner graph of an LDPC code, the degree of a variable node and a check node refers to the number of edges connected to each node, which corresponds to the number of non-zero entries in the column or row corresponding to the node in the parity-check matrix of the LDPC code. For example, in FIG. 2, degrees of the variable nodes $x_1(202)$, $x_2(204)$, $x_3(206)$, $x_4(208)$, $x_5(210)$, $x_6(212)$, $x_7(214)$, and $x_8(216)$ are 4, 3, 3, 3, 2, 2, 2, and 2, respectively, and degrees of the check nodes 218, 220, 222, and 224 are 6, 5, 5, and 5, respectively. The number of non-zero entries in each column of the parity-check matrix $H_1$ in FIG. 2, which corresponds to the variable nodes in FIG. 2 matches degrees 4, 3, 3, 3, 2, 2, 2, and 2 of the above-described variable nodes in that order, and the number of non-zero entries in each row of the parity-check matrix $H_1$ in FIG. 2, which corresponds to the check nodes in FIG. 2 matches degrees 6, 5, 5, and 5 of the above-described check nodes in that order. For this reason, the degree of each variable node is also referred to as a column degree or column weight, and the degree of the check node is also referred to as a row degree or row weight.

LDPC encoded codeword bits may be decoded using an iterative decoding algorithm based on the sum-product algorithm on a bipartite graph, as illustrated in FIG. 2. The sum-product algorithm is a type of message passing algorithm, which exchanges messages through edges of a bipartite graph and updates output messages by computing them from messages input at variable nodes or check nodes.

A value of the i-th coded bit may be determined based on the message of the i-th variable node. Both hard decision and soft decision methods may be used for determining the value of the i-th coded bit. Therefore, the performance of an i-th codeword bit $c_i$ of the LDPC code corresponds to the performance of the i-th variable node of the Tanner graph, which may be determined by the positions and number of 1s in the i-th column of the parity-check matrix. In other words, the performance of the $N_{ldpc}$ codeword bits may be influenced by the positions and number of 1s in the parity-check matrix, indicating that the performance of the LDPC code is highly dependent on the parity-check matrix. Therefore, in order to design an LDPC code with excellent performance, a method of designing a good parity-check matrix is required.

In communication and broadcasting systems, quasi-cyclic LDPC codes (or QC-LDPC codes, hereinafter, referred to as QC-LDPC codes), which employ parity-check matrices in a quasi-cyclic form, are typically used for ease of implementation. According to the communication and broadcasting system, there are cases where a parity-check matrix that does not have a fully quasi-cyclic structure but exhibits a structure similar to it is used, and although such LDPC codes may not be strictly classified as QC-LDPC codes in an algebraic sense, they are often conveniently classified as QC -LDPC codes.

A typical QC-LDPC code may be characterized by a parity-check matrix may include zero matrices or circulant permutation matrices (or circular permutation matrices), each in the form of a small square matrix. In the case, a permutation matrix refers to a matrix in which each row or column includes only one entry of 1, with all other entries being 0. Further, a circulant permutation matrix refers to a matrix obtained by cyclically shifting entries of an identity matrix to the right or left.

Hereinafter, the QC-LDPC code is described in greater detail.

As in Equation 2, a ZxZ circulant permutation matrix $P = (P_{i,j})$ is defined. $P_{i,j}$ denotes the entry of the i-th row and j-th column in the matrix P. ($0 \le i,\ j < Z$)

[Equation 2-1]

$$P_{i,j} = \begin{cases} 1 & \text{if } i + 1 \equiv j \pmod{Z} \\ 0 & \text{otherwise.} \end{cases}$$

For the permutation matrix P defined as above, $P^k$ ($0 \le i < Z$) is a circulant permutation matrix in the form that circularly shifts entries of a ZxZ identity matrix to the right by k times. The circulant permutation matrix may be defined as in [Equation 2-2], in which case, $P^k$ is a circulant permutation matrix in the form that circularly shifts entries of the ZxZ identity matrix to the left by k times.

[Equation 2-2]

$$P_{i,j} = \begin{cases} 1 & \text{if } i \equiv j + 1 \pmod{Z} \\ 0 & \text{otherwise.} \end{cases}$$

In the disclosure, for convenience, various embodiments are described using circulant permutation matrices defined based on [Equation 2-1], however, because the circulant permutation matrices defined in [Equation 2-1] and [Equation 2-2] differ only in notation while sharing the same fundamental algebraic properties, a circulant permutation matrix defined based on Equation 2-2 may be used in various embodiments of the disclosure, or various types of circulant permutation matrices with equivalent algebraic properties may be used.

The parity-check matrix H of the simplest QC-LDPC code may be represented in Equation 3.

[Equation 3]

$$\mathbf{H} = \begin{bmatrix} P^{V_{1,1}} & P^{V_{1,2}} & \cdots & P^{V_{1,n_b}} \\ P^{V_{2,1}} & P^{V_{2,2}} & \cdots & P^{V_{2,n_b}} \\ \vdots & \vdots & \ddots & \vdots \\ P^{V_{m_b,1}} & P^{V_{m_b,2}} & \cdots & P^{V_{m_b,n_b}} \end{bmatrix}$$

For convenience, in the case where $P^{-1}$ is a ZxZ zero matrix, each index $V_{i,j}$ of the circulant permutation matrix or zero matrix in Equation 3 has one of values {-1, 0, 1, 2,..., Z-1}. The identity matrix may be expressed as $P^0$ or I, and the zero matrix may be expressed as $P^{-1}$ or 0. Further, in the parity-check matrix H of Equation 3, because the number of column blocks is $n_b$ and the number of row blocks is $m_b$, the size of the parity-check matrix H is $n_b Z \times m_b Z$.

If the parity-check matrix in Equation 3 has a full rank, the length of the information bit of the QC-LDPC code corresponding to the parity-check matrix is $(n_b - m_b)Z$. For convenience, $k_b = (n_b - m_b)$ column blocks corresponding to the information bits may be referred to as information word column blocks, and the number of information bits is $k_b Z$, and the remaining $m_b$ column blocks corresponding to the parity bits may be referred to as parity column blocks. In this case, the number of parity bits is $m_b Z$, For reference, in the case where the parity-check matrix in Equation 3 does not have a full rank, the number of the information bit becomes greater than $(n_b - m_b)Z$, that is, $k_b Z$, and the number of parity bits becomes less than $m_b Z$.

In general, an $m_b \times n_b$ binary matrix obtained by replacing each circulant permutation matrix and zero matrix in the parity-check matrix of Equation 3 with 1 and 0, respectively, is referred to as a mother matrix, base matrix, or base graph of the parity-check matrix H, and is denoted by M(H) or $\mathbf{H}_{BG}$. Further, an $m_b \times n_b$ integer matrix obtained, as illustrated in Equation 4, by assigning an exponent to each circulant permutation matrix or zero matrix, is referred to as an exponent matrix $V(\mathbf{H})$ of the parity-check matrix H.

[Equation 4]

$$V(\mathbf{H}) = \begin{bmatrix} V_{1,1} & V_{1,2} & \cdots & V_{1,n_b} \\ V_{2,1} & V_{2,2} & \cdots & V_{2,n_b} \\ \vdots & \vdots & \ddots & \vdots \\ V_{m_b,1} & V_{m_b,2} & \cdots & V_{m_b,n_b} \end{bmatrix}$$

Names of these matrices are merely examples, and the exponent matrix V(H) may be referred to by other names. For example, because the exponent of each circulant permutation matrix corresponds to the value by which the identity matrix is circularly shifted, as in [Equation 2-1] or [Equation 2-2], each exponent may be referred to as a shift value (or circular shift value), and V(H) may also be referred to as a circulant shift value matrix or a shift value matrix. In general, in the case where the value Z corresponding to the size of the exponent matrix or shift value matrix and the circulant permutation matrix or zero matrix is given, the parity-check matrix may be determined or identified. For this reason, according to the mathematical definition, a parity-check matrix refers to a binary matrix H that satisfies the condition of Equation 1, but in some cases, the exponent matrix or shift value matrix may be also conveniently referred to as the parity-check matrix.

Because each integer included in the exponent matrix or the shift value matrix corresponds to a circulant permutation matrix in the parity-check matrix, the exponent matrix may, for convenience, be expressed as a sequence of integers. In general, a parity-check matrix may be represented not only by an exponent matrix, but also by various sequences that express algebraically equivalent properties. In the disclosure, for convenience, the parity-check matrix is represented using sequences indicating positions of 1s in the exponent matrix or the parity-check matrix, but because there are various ways to represent positions of 1s or 0s in the parity-check matrix as sequences, it is not limited to the method expressed in this disclosure and may be expressed in the form of various sequences or matrices that exhibit the algebraically equivalent effect. The sequences may be referred to in various ways, such as LDPC sequences, LDPC code sequences, parity-check matrix sequences, or (circulant) shift value sequences, in order to distinguish them from other type of sequences.

A transceiver may directly generate a parity-check matrix to perform LDPC encoding and decoding, but according to implementation characteristics, LDPC encoding and decoding may also be performed based on an exponent matrix, a shift value matrix, or a sequence that has the same effect algebraically as the parity-check matrix. Therefore, in the disclosure, for convenience, although encoding and decoding using a parity-check matrix is described, an actual transceiver may implement encoding and decoding through various methods that may obtain the same effect as the parity-check matrix.

For reference, the term "algebraically equivalent effect" may refer, for example, to two or more different representations being described to be, or transformed into, identical forms logically or mathematically. For example, for codes defined by matrices, such as LDPC codes, it may indicate that algebraic values defined by matrices, such as minimum distance, rank, and cycle characteristics in Tanner graphs, are identical, or that the basic structure or operation remains the same during the encoding/decoding process. For example, if the same matrix may be obtained through appropriate column and row permutations, two matrices may be regarded as algebraically equivalent from a coding viewpoint. Further, various transposes that do not alter the essential properties of the code may provide algebraically equivalent effects.

As an example, when there is the following matrix A, examples of various transformations that provide algebraically equivalent effects are illustrated in $A_1$ through $A_8$.

$$A = \begin{bmatrix} P^{a_{1,1}} & P^{a_{1,2}} & P^{a_{1,3}} & P^{a_{1,4}} \\ P^{a_{2,1}} & P^{a_{2,2}} & P^{a_{2,3}} & P^{a_{2,4}} \\ P^{a_{3,1}} & P^{a_{3,2}} & P^{a_{3,3}} & P^{a_{3,4}} \\ P^{a_{4,1}} & P^{a_{4,2}} & P^{a_{4,3}} & P^{a_{4,4}} \end{bmatrix}$$

$$A_1 = \begin{bmatrix} P^{a_{1,1}} & P^{a_{1,3}} & P^{a_{1,2}} & P^{a_{1,4}} \\ P^{a_{2,1}} & P^{a_{2,3}} & P^{a_{2,2}} & P^{a_{2,4}} \\ P^{a_{3,1}} & P^{a_{3,3}} & P^{a_{3,2}} & P^{a_{3,4}} \\ P^{a_{4,1}} & P^{a_{4,3}} & P^{a_{4,2}} & P^{a_{4,4}} \end{bmatrix}, \quad A_2 = \begin{bmatrix} P^{a_{3,1}} & P^{a_{3,3}} & P^{a_{3,2}} & P^{a_{3,4}} \\ P^{a_{2,1}} & P^{a_{2,3}} & P^{a_{2,2}} & P^{a_{2,4}} \\ P^{a_{1,1}} & P^{a_{1,3}} & P^{a_{1,2}} & P^{a_{1,4}} \\ P^{a_{4,1}} & P^{a_{4,3}} & P^{a_{4,2}} & P^{a_{4,4}} \end{bmatrix},$$

$$A_3 = \begin{bmatrix} P^{a_{1,1}+x} & P^{a_{1,2}} & P^{a_{1,3}+y} & P^{a_{1,4}} \\ P^{a_{2,1}+x} & P^{a_{2,2}} & P^{a_{2,3}+y} & P^{a_{2,4}} \\ P^{a_{3,1}+x} & P^{a_{3,2}} & P^{a_{3,3}+y} & P^{a_{3,4}} \\ P^{a_{4,1}+x} & P^{a_{4,2}} & P^{a_{4,3}+y} & P^{a_{4,4}} \end{bmatrix},$$

$$A_4 = \begin{bmatrix} P^{a_{1,1}+x} & P^{a_{1,2}} & P^{a_{1,3}+y} & P^{a_{1,4}} \\ P^{a_{2,1}+x+z} & P^{a_{2,2}+z} & P^{a_{2,3}+y+z} & P^{a_{2,4}+z} \\ P^{a_{3,1}+x} & P^{a_{3,2}} & P^{a_{3,3}+y} & P^{a_{3,4}} \\ P^{a_{4,1}+x+w} & P^{a_{4,2}+w} & P^{a_{4,3}+y+w} & P^{a_{4,4}+w} \end{bmatrix},$$

$$A_5 = \begin{bmatrix} P^{-a_{1,1}} & P^{-a_{2,1}} & P^{-a_{3,1}} & P^{-a_{4,1}} \\ P^{-a_{1,2}} & P^{-a_{2,2}} & P^{-a_{3,2}} & P^{-a_{4,2}} \\ P^{-a_{1,3}} & P^{-a_{2,3}} & P^{-a_{3,3}} & P^{-a_{4,3}} \\ P^{-a_{1,4}} & P^{-a_{2,4}} & P^{-a_{3,4}} & P^{-a_{4,4}} \end{bmatrix},$$

$$A_6 = \begin{bmatrix} P^{a_{1,1}} & P^{a_{2,1}} & P^{a_{3,1}} & P^{a_{4,1}} \\ P^{a_{1,2}} & P^{a_{2,2}} & P^{a_{3,2}} & P^{a_{4,2}} \\ P^{a_{1,3}} & P^{a_{2,3}} & P^{a_{3,3}} & P^{a_{4,3}} \\ P^{a_{1,4}} & P^{a_{2,4}} & P^{a_{3,4}} & P^{a_{4,4}} \end{bmatrix},$$

$$A_7 = \begin{bmatrix} P^{-a_{1,1}} & P^{-a_{1,2}} & P^{-a_{1,3}} & P^{-a_{1,4}} \\ P^{-a_{2,1}} & P^{-a_{2,2}} & P^{-a_{2,3}} & P^{-a_{2,4}} \\ P^{-a_{3,1}} & P^{-a_{3,2}} & P^{-a_{3,3}} & P^{-a_{3,4}} \\ P^{-a_{4,1}} & P^{-a_{4,2}} & P^{-a_{4,3}} & P^{-a_{4,4}} \end{bmatrix},$$

$$A_8 = \begin{bmatrix} P^{ka_{1,1}} & P^{ka_{1,2}} & P^{ka_{1,3}} & P^{ka_{1,4}} \\ P^{ka_{2,1}} & P^{ka_{2,2}} & P^{ka_{2,3}} & P^{ka_{2,4}} \\ P^{ka_{3,1}} & P^{ka_{3,2}} & P^{ka_{3,3}} & P^{ka_{3,4}} \\ P^{ka_{4,1}} & P^{ka_{4,2}} & P^{ka_{4,3}} & P^{ka_{4,4}} \end{bmatrix},$$

(where k is an integer coprime to $Z$)

$A_1$ is an example of a block-wise permutation that swaps second and third column blocks of $A$. $A_2$ is an example of a block-wise permutation that additionally swaps first and third row blocks in $A_1$. $A_3$ is an example of applying a circulant permutation only to first and third column blocks of $A$. $A_4$ is an example of applying a circulant permutation only to second and fourth row blocks in $A_3$. $A_5$ is an example of applying a transpose to $A$. $A_6$ is an example of applying a block-wise transpose to $A$. $A_7$ is an example of inverting the signs of each exponent (or circulant shift value) in $A$ (for convenience, because the use of a negative exponent (or shift value) in the case of representing a ZxZ zero matrix as $P^{-1}$ may cause confusion, ($-a_{i,j}$) may be expressed as a positive value, such as ($Z - a_{i,j}$). $A_8$ is an example of applying an affine transformation with a constant term of 0 to $A$ (In general, it may be applied to the case where the constant term is not 0). For reference, for convenience, although the above examples have described the case where $P^{a_{i,j}}$ has no entry of a ZxZ zero matrix, when a zero matrix is included, a portion corresponding to the zero matrix is always a zero matrix regardless of transformation. For example, in $A$, if $P^{a_{2,3}}$ is a zero matrix, even in $A_1$, $A_2$, and $A_6$, $P^{a_{2,3}}$ is a zero matrix , and in $A_3$ and $A_4$, $P^{a_{2,3}+y}$ and $P^{a_{2,3}+y+z}$ each are zero matrices, in $A_5$ and $A_7$, $P^{-a_{2,3}}$ is a zero matrix, and in $A_8$, $P^{ka_{2,3}}$ is a zero matrix.

The above transformations are merely examples, and various other transformations may exist. While each transformation may be applied independently, they may also be applied in appropriate combination and overlap. The characteristic of each transformation or combination of transformations is that they may be reverted to the original matrix through an appropriate invertible transformation process.

Because the above various transformations or combinations thereof are essentially reversible transformations, such as simple rearrangements of bits (or variable nodes) or check nodes on a Tanner graph, symmetric transformations, or structure-preserving reversible transformations, the instantaneous performance may vary according to the given channel conditions, but the average performance may remain the same in terms of code performance. Accordingly, in the disclosure, all parity-check matrices obtained through transformations that may obtain algebraically equivalent effects are regarded as identical parity-check matrices.

For convenience, the case where there is a single circulant permutation matrix corresponding to a single Z×Z square block has been described, but the same may also be applied to the case where a single block includes multiple circulant permutation matrices. For example, when two circulant permutation matrices $P^{V_{ij}^{(1)}}$ and $P^{V_{ij}^{(2)}}$ correspond to the position of one i-th row block and one j-th column block, as in Equation 5, they may be simply expressed in the form of the sum as $P^{V_{ij}^{(1)}} + P^{V_{ij}^{(2)}}$, and the corresponding exponent matrix (or circulant ¨ shift value matrix) may be expressed as in Equation 6. From Equation 6, it may be seen that two integers correspond to the i-th row and j-th column corresponding to the row block and column block that include the sum of the multiple circulant permutation matrices.

[Equation 5]

$$H = \begin{bmatrix} & P^{V_{i,j}^{(1)}} + P^{V_{i,j}^{(2)}} & \end{bmatrix}$$

[Equation 6]

$$V(H) = \begin{bmatrix} & \left( V_{i,j}^{(1)}, V_{i,j}^{(2)} \right) & \end{bmatrix}$$

As in the above embodiment, in general, a QC-LDPC code may have one or more circulant permutation matrices corresponding to one row block and one column block in a parity-check matrix, and for reference, a ZxZ matrix in which multiple circulant permutation matrices are overlapped within one row block and one column block is referred to as a circulant matrix (or circulant or circular matrix). In general, each entry of a circulant matrix may have not only binary numbers but also arbitrary numbers, but in the disclosure, because binary codes are described for convenience, the circulant matrix refers to a binary circulant matrix. The algebraic structures and properties of the disclosure may also be extended in a similar manner to non-binary codes, but detailed descriptions thereof are omitted.

The base matrix (or mother matrix or base graph) for the parity-check matrix and the exponent matrix (or circulant shift value matrix) of Equations 5 and 6 refer to a binary matrix obtained by replacing each circulant permutation matrix and zero matrix with 1 and 0, respectively, in a manner similar to the definition used in Equation 3, and a circulant matrix included in one block (e.g., the sum of multiple circulant permutation matrices) may also be replaced with 1.

A simple example of the relationship among the parity-check matrix, the exponent matrix (or circulant shift matrix), and the base matrix is presented in [Equation 7].

[Equation 7]

$$\mathbf{H_1} = \begin{bmatrix} P^{159} & O & P^0 & P^0 & O & O \\ P^{117} & P^{109} & O & P^0 & P^0 & O \\ O & P^{225} & P^1 & O & P^0 & P^0 \\ P^{84} & P^{211} & P^0 & O & O & P^0 \end{bmatrix} \left( = \right.$$

$$\left. \begin{bmatrix} P^{159} & O & I & I & O & O \\ P^{117} & P^{109} & O & I & I & O \\ O & P^{225} & P^1 & O & I & I \\ P^{84} & P^{211} & I & O & O & I \end{bmatrix} \right),$$

$$M(\mathbf{H_1}) = \begin{bmatrix} 1 & 0 & 1 & 1 & 0 & 0 \\ 1 & 1 & 0 & 1 & 1 & 0 \\ 0 & 1 & 1 & 0 & 1 & 1 \\ 1 & 1 & 1 & 0 & 0 & 1 \end{bmatrix},$$

$$V(\mathbf{H_1}) = \begin{bmatrix} 159 & -1 & 0 & 0 & -1 & -1 \\ 117 & 109 & -1 & 0 & 0 & -1 \\ -1 & 225 & 1 & -1 & 0 & 0 \\ 84 & 211 & 0 & -1 & -1 & 0 \end{bmatrix}.$$

In [Equation 7], the exponent (or the shift value) of a ZxZ zero matrix is expressed as -1, which is merely one example, and may be expressed in various ways. The matrix expression method of the [Equation 7] may be expressed in various other ways, and as a specific example, the expression method of the parity-check matrix of the LDPC code defined in 3GPP TS 38.212, which is a 3GPP 5G standard specification, may be used. In 3GPP TS 38.212, because sizes of parity-check matrices of the LDPC code corresponding to Base Graph 1 (BG1) and Base Graph 2 (BG2) are too large, they are represented in tables, and when the same expression method is applied to the matrices of [Equation 7], the result is presented in [Table 1].

$H_{BG1}$ is a 4 x 8 matrix, and $\mathbf{H_1}$ is a 4Zx8Z matrix. Entries of the base matrix (or base graph) and the parity-check matrix not represented in Table 1 correspond to 0 or to a ZxZ zero matrix.

[Table 1]

| H<sub>BG1</sub> | | $V_{i,j}$ |
|---|---|---|
| Row index $i$ | Column index $j$ | |
| 0 | 0 | 159 |
| | 2 | 0 |
| | 3 | 0 |
| 1 | 0 | 117 |
| | 1 | 109 |
| | 3 | 0 |
| | 4 | 0 |
| 2 | 1 | 225 |
| | 2 | 1 |
| | 4 | 0 |
| | 5 | 0 |

(continued)

| H_BG1 | | V_{i,j} |
|---|---|---|
| Row index $i$ | Column index $j$ | |
| 3 | 0 | 84 |
| | 1 | 211 |
| | 2 | 0 |
| | 5 | 0 |

If the base matrix and exponent matrix in [Equation 7] are expressed using a sequence, they may be expressed in the following manner.

$M(\mathbf{H_1})$:

023
0 1 3 4
1 2 4 5
0 125

$V(\mathbf{H_1})$:

159 0 0
117 109 0 0
225 1 0 0
84 211 0 0

When the exponent matrix $V(\mathbf{H_1})$ is expressed as a sequence as described above, it may be conveniently referred to in various ways, such as a shift sequence, a shift value sequence, an LDPC sequence, and the like. In the above sequence expression method, $M(\mathbf{H_1})$ denotes a method of listing, for each row, positions of columns whose entries are not 0, and $V(\mathbf{H_1})$ denotes a method of listing, for each row, exponents or shift values of each circulant permutation matrix that is not a zero matrix. From the above sequences, the exponent matrix (or shift value matrix) may be accurately defined, and if information on the Z value is obtained, the parity-check matrix may also be accurately defined.

Another simple example of the relationship among a parity-check matrix, an exponent matrix (or circulant shift matrix), and a base matrix is presented in [Equation 8]. The example in [Equation 8] illustrates the case where the parity-check matrix includes a circulant matrix in which at least two circulant permutation matrices correspond to at least one ZxZ block.

[Equation 8]

$$\mathbf{H_2} = \begin{bmatrix} P^{117} + P^{159} & P^{109} & P^0 & P^0 \\ P^{84} & P^{211} + P^{225} & P^1 + P^3 & P^0 \end{bmatrix}.$$

$$M(\mathbf{H_2}) = \begin{bmatrix} 1 & 1 & 1 & 1 \\ 1 & 1 & 1 & 1 \end{bmatrix},$$

$$V(\mathbf{H_2}) = \begin{bmatrix} 117,159 & 109 & 0 & 0 \\ 84 & 211,225 & 1,3 & 0 \end{bmatrix},$$

$$W(\mathbf{H_2}) = \begin{bmatrix} 2 & 1 & 1 & 1 \\ 1 & 2 & 2 & 1 \end{bmatrix}.$$

For reference, in [Equation 8], $W(\mathbf{H_2})$ is a weight matrix for the base matrix, the exponent matrix, or the parity-check matrix, and is a matrix that expresses how many circulant permutation matrices correspond to the i-th row, the j-th column in the base matrix and the exponent matrix, or the i-th row block, the j-th column block in the parity-check matrix. For

example, $W(\mathbf{H_2})$ may refer, for example, to a matrix that represents the number of circulant permutation matrices of a ZxZ circulant matrix corresponding to the i-th row block, the j-th column block in the parity-check matrix, as entries of the i-th row and the j-th column. That is, $W(\mathbf{H_2})$ is a matrix that represents 0 as an entry when a zero matrix corresponds, and w as an entry when w circulant permutation matrices correspond. (For reference, a zero matrix may be regarded as a circulant matrix in a broad sense, but it is not a circulant 'permutation' matrix.)

If the base matrix, parity-check matrix, or circulant shift value matrix (or exponent matrix) defined in [Equation 8] is expressed by applying the method of expressing parity-check matrices of LDPC codes in 3GPP TS 38.212 as in [Table 1], it may be expressed as in [Table 2].

$\mathbf{H_{BG2}}$ is a 2x4 matrix, $\mathbf{H_2}$ is a 2Zx4Z matrix. Entries of a base matrix (or base graph) and a parity-check matrix not represented in Table 2 correspond to 0 or to a ZxZ zero matrix.

[Table 2]

| Row index i | Column index j | $V_{i,j}$ |
|---|---|---|
| 0 | 0 | 117,159 |
| | 1 | 109 |
| | 2 | 0 |
| | 3 | 0 |
| 1 | 0 | 84 |
| | 1 | 211, 225 |
| | 2 | 1, 3 |
| | 3 | 0 |

If the base matrix and exponent matrix of [Equation 8] are expressed using sequences, they may be represented in the following manner.

$M(\mathbf{H_2})$:

    0 1 2 3
    0 1 2 3

$V(\mathbf{H_2})$:

    (117, 159) 109 0 0
    84 (211, 225) (1, 3) 0

As another expression method, they may also be expressed in a form including sequences using a weight matrix, as follows.

$M(\mathbf{H_2})$:

    0 1 2 3
    0 1 2 3

$W(\mathbf{H_2})$:

    2 1 1 1

    122 1

$V(\mathbf{H_2})$:

    117 159 109 0 0
    84 211 225 1 3 0

In the above expression method, $M(\mathbf{H}_2)$ denotes a method of listing, for each row, positions of columns whose entries are not 0, $W(\mathbf{H}_2)$ is a matrix defined based on the number of circulant permutation matrices of circulant matrices corresponding to the base matrix, the exponent matrix, or the parity-check matrix, and $V(\mathbf{H}_2)$ denotes a method of listing, for each row, exponents or shift values of each circulant matrix that is not a zero matrix. From these sequences, the exponent matrix may be accurately defined, and if information on a Z value is obtained, the parity-check matrix may also be accurately defined.

Because the performance of an LDPC code is determined by its parity-check matrix, it is necessary to design the parity-check matrix to achieve high-performance LDPC codes. Further, an LDPC encoding or decoding method capable of supporting various input lengths and code rates is required.

Lifting may be used not only for the efficient design of QC-LDPC codes, but may also refer to a method of generating parity-check matrices of various lengths or LDPC codewords using given base matrices and exponent matrices. That is, lifting may be applied to efficiently design a very large parity-check matrix by configuring a Z value, which determines the size of a circulant permutation matrix or a zero matrix from a given small parent matrix, according to specific rules, or may refer to a method of generating parity-check matrices of various lengths or LDPC codewords by applying an appropriate Z value to a given exponent matrix or its corresponding sequence.

The characteristics of the existing lifting method and the QC-LDPC code designed through lifting are briefly described with reference to Reference [Myung2006].

Reference [Myung2006]

S. Myung, K. Yang, and Y. Kim, "Lifting Methods for Quasi-Cyclic LDPC Codes," IEEE Communications Letters. vol. 10, pp. 489-491, June 2006.

When an LDPC code $C_0$ is given, the S QC-LDPC codes to be designed through the lifting method are denoted as $C_1,..., C_s$, and values corresponding to sizes of row and column blocks of the parity-check matrix of each QC-LDPC code are denoted as $L_k$. $C_0$ corresponds to the smallest LDPC code having the mother matrix for codes $C_1,..., C_S$ as the parity-check matrix., and the value of $Z_0$ corresponding to the row block and column block size is 1. For convenience, the parity-check matrix $\mathbf{H}_k$ of each code $C_k$ has an $m \times n$ exponent matrix $V(\mathbf{H}_k) = \left(V_{ij}^{(k)}\right)$, and each exponent $V_{i,j}^{(k)}$ is selected from one of values $\{-1, 0, 1, 2,..., Z_{k-1}\}$.

The existing lifting method includes steps such as $C_0 \to C_1 \to ... \to C_S$ and is characterized by satisfying the condition such as $Z_{k+1} = q_{k+1} Z_k$ ($q_{k+1}$ is the positive integer, k=0,1,..., S-1). Due to the properties of the lifting process, all the QC-LDPC codes $C_0, C_1,..., C_s$ may be represented using Equations 9 or 10 by storing the parity-check matrix $\mathbf{H}_S$ of $C_s$, according to the lifting method.

$$[\text{Equation 9}]$$

$$V(\mathbf{H}_k) \equiv \left\lfloor \frac{Z_k}{Z_S} V(\mathbf{H}_S) \right\rfloor$$

or

$$[\text{Equation 10}]$$

$$V(\mathbf{H}_k) \equiv V(\mathbf{H}_S) \pmod{Z_k}$$

In addition to a method of designing larger QC-LDPC codes $C_1,..., C_S$ from $C_0$, a method of generating smaller codes $C_i$ (i=k-1, k-2,... 1, 0) from a larger code $C_k$ using an appropriate method such as Equation 9 or Equation 10 may also be referred to as lifting. For reference, in 3GPP TS 38.212, LDPC codes of various lengths may be generated using the lifting method of Equation 10.

In the lifting methods of Equation 9 or 10, the lifting sizes $Z_k$, which correspond to row-block or column-block sizes in the parity-check matrices of the respective QC-LDPC codes $C_k$ have a multiple relationship with one another, and the corresponding exponent matrices are accordingly selected by a specific method. Such conventional lifting methods facilitate the design of QC-LDPC codes with improved error floor performance by enhancing the algebraic or graphical properties of each parity-check matrix designed through lifting.

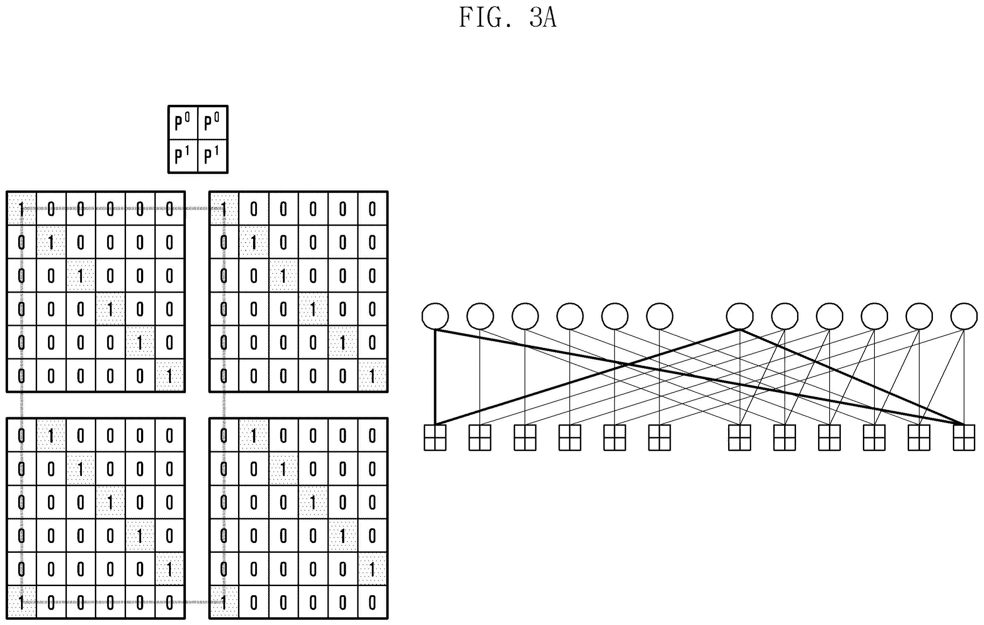

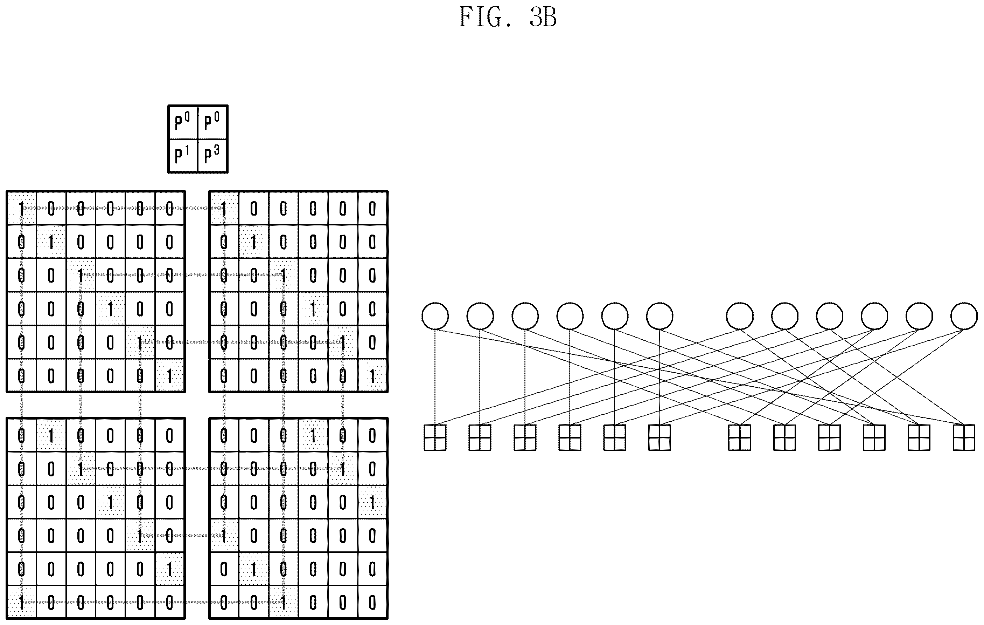

FIGS. 3A and 3B are diagrams illustrating that cycle characteristics of a QC-LDPC code may vary significantly according to the exponent matrix according to various embodiments.

FIG. 3A is a diagram illustrating cycle characteristics of a QC-LDPC code.

The exponent matrix of FIG. 3A is $\begin{bmatrix} P^0 & P^0 \\ P^1 & P^1 \end{bmatrix}_{(Z=6)}$ , and in this case, there may be many 4-cycles in the Tanner graph. Codes with many short cycles like this may significantly degrade decoding performance.

FIG. 3B is a diagram illustrating cycle characteristics of a QC-LDPC code.

The exponent matrix of FIG. 3B is $\begin{bmatrix} P^0 & P^0 \\ P^1 & P^3 \end{bmatrix}_{(Z=6)}$ , and in this case, the length of the shortest cycle in the Tanner graph is 12. Because cycle characteristics in the Tanner graph may change significantly by modifying even a single exponent in the circulant permutation matrix, the selection of the exponent matrix plays an important role in improving the performance of the LDPC code. The lifting method may be regarded as one of design methods that take such cycle characteristics into account.

In general, lifting may be considered as modifying values of entries of the exponent matrix in Equation 4 for various values of Z, and using the values for LDPC encoding and decoding. For example, when the exponent matrix in Equation 4 is denoted as $V(\mathbf{H}) = (V_{i,j})$ and the exponent matrix transformed according to the value of Z is denoted as $V(\mathbf{H}(Z)) = (V_{i,j}(Z))$, a transformation such as that described in Equation 11 may be generally applied.

[Equation 11]

$$V_{i,j}(Z) = \begin{cases} V_{i,j} & V_{i,j} < 0 \\ f(V_{i,j}, Z) & V_{i,j} \geq 0 \end{cases} \quad \text{or} \quad V_{i,j}(Z) = \begin{cases} V_{i,j} & V_{i,j} \leq 0 \\ f(V_{i,j}, Z) & V_{i,j} > 0 \end{cases}$$

In Equation 11, $f(x, Z)$ may be defined in various forms, and for example, [Equation 9] may correspond to $f(x, Z) = \left\lfloor \frac{Z}{Z_{\max}} x \right\rfloor (Z_{\max} = Z_S)$ , and [Equation 10] may correspond to $f(x, Z) = \mathrm{mod}(x, Z)$. (where mod(a,b) denotes a modulo-b operation applied to a). Further, $f(x, Z)$ may be defined in various ways, as illustrated in Equation 12.

[Equation 12]

$$f(x, Z) = \mathrm{mod}(x, 2^{\lfloor \log_2 Z \rfloor})$$

or

$$f(x, Z) = \left\lfloor \frac{x}{2^{D - \lfloor \log_2 Z \rfloor}} \right\rfloor$$

or

$$f(x, Z) = \left\lfloor \frac{Z}{D} x \right\rfloor$$

In Equation 12, D denotes a predefined positive integer constant.

For reference, in the transformation equation (or transformation function) f of Equation 11, a reference value (or a reference value of $V_{i,j}$ used for distinguishing between applying $V_{i,j}$ and $f(V_{i,j}, Z)$) applying the transformation equation is represented as 0 for convenience, but this reference value may vary according to the lifting size Z value to be supported or the method of representing a ZxZ zero matrix. For example, in the case where a ZxZ zero matrix is defined using a predetermined number or symbol other than the negative integer -1, the reference value for applying the transformation equation f may be defined differently. Where the exponent matrix or LDPC sequence is expressed based on a manner that omits exponents corresponding to zero matrices from the beginning, the rule for handling exponent values less than 0 in Equation 11 may be omitted. Because the transformation equation f is applied to circulant permutation matrices or circulant matrices other than zero matrices, the omission of transformation for ZxZ zero matrices may be represented in various ways.

As an example embodiment of the disclosure, a case is described in which LDPC encoding and decoding are applied based on a plurality of exponent matrices or LDPC sequences derived from a single predetermined base matrix. For example, the base matrix is fixed to one, and the exponent matrix, (circulant) shift value matrix, or LDPC sequence of the LDPC code defined based on the base matrix may be determined, and variable-length LDPC encoding and decoding are performed by applying lifting according to the lifting size included in each lifting size group from the matrix or sequence. This method has a characteristic that entries or numbers of the exponent matrix or LDPC sequence of the LDPC code may have different values, but their positions on the base matrix remain exactly the same.

The LDPC codes defined in TS 38.212, a 3GPP 5G standard specification, are also designed in this manner, and in the standard, two base matrices $\mathbf{H_{BG}}$ are defined, and for each base matrix, eight exponent matrices (or circulant shift value matrices) $V\left(\mathbf{H}_{i_{LS}}\right) = \left(V_{i,j}^{(i_{LS})}\right)$ ($i_{LS}$ = 0, 1, 2, ..., 7) are defined and may be used for LDPC encoding. For example, according to the standard, various parity-check matrices for LDPC codes may be determined based on a total of two base matrices, 16 index matrices, and an appropriate lifting size Z. In the TS 38.212 standard, the matrix corresponding to $V(\mathbf{H}_{i_{LS}})$ is referred to as the parity-check matrix, whereas the matrix that corresponds to the conventional parity-check matrix is referred to as matrix-**H.** Although $V(\mathbf{H}_{i_{LS}})$ is a matrix including integers, and a lifting size $Z$ should be given to construct a parity-check matrix in the strict sense, as described earlier, $V(\mathbf{H}_{i_{LS}})$ may also be referred to as a parity-check matrix for convenience.

Hereinafter, for convenience of description, the LDPC code and its representation method defined in the 3GPP 5G standard specification TS 38.212 will primarily be used, but in some cases, conventional mathematical notations or alternative representations may also be adopted. First, lifting sizes Z to be supported for determining the parity-check matrix or matrix-H of the LDPC code are illustrated in [Table 3]. (Hereinafter, the set index iLS for each lifting size set is provided as an example and may appear in a different order.)

[Table 3]

| Set index ($i_{LS}$) | Set of lifting sizes (Z) |
|---|---|
| 0 | {2, 4, 8, 16, 32, 64, 128, 256} |
| 1 | {3, 6, 12, 24, 48, 96, 192, 384} |
| 2 | {5, 10, 20, 40, 80, 160, 320} |
| 3 | {7, 14, 28, 56, 112, 224} |
| 4 | {9, 18, 36, 72, 144, 288} |
| 5 | {11, 22, 44, 88, 176, 352} |
| 6 | {13, 26, 52, 104, 208} |
| 7 | {15, 30, 60, 120, 240} |

In the disclosure, the lifting sizes or block sizes are basically represented as illustrated in [Table 3], but they may also be represented in the manner as illustrated in [Table 4], and various other representation methods are also possible.

[Table 4]

| Set index ($i_{LS}$) | Set of lifting sizes (Z) |
|---|---|
| 0 | $2 \times 2^k$, $k$ = 0, 1, 2, ... , 7 |
| 1 | $3 \times 2^k$, $k$ = 0, 1, 2, ... , 7 |
| 2 | $5 \times 2^k$, $k$ = 0,1, 2, ... , 6 |
| 3 | $7 \times 2^k$, $k$ = 0, 1, 2, ... , 5 |
| 4 | $9 \times 2^k$, $k$ = 0, 1, 2, ... , 5 |
| 5 | $11 \times 2^k$, $k$ = 0, 1, 2, ... , 5 |
| 6 | $13 \times 2^k$, $k$ =0, 1, 2, ... , 4 |
| 7 | $15 \times 2^k$, $k$ = 0, 1, 2, ..., 4 |

In 3GPP 5G, as illustrated in [Table 3] or [Table 4], lifting sizes or block sizes Z may be divided into multiple sets (or groups). (Hereinafter, for convenience, they are referred to as lifting size sets (or groups) or block size sets (or groups))

In 3GPP 5G standard, a parity-check matrix or matrix-**H** is determined based on the exponent matrix $V(\mathbf{H}_{i_{LS}}(Z)) \equiv$ $V(\mathbf{H}_{i_{LS}})$ (mod $Z$) that may be obtained using the lifting method of [Equation 10]. Thus, when $V\left(\mathbf{H}_{i_{LS}}\right) = \left(V_{i,j}^{(i_{LS})}\right)$

and $V\left(\mathbf{H}_{i_{LS}}(Z)\right) = \left(V_{i,j}^{(i_{LS})}(Z)\right)$, $V_{i,j}^{(i_{LS})}(Z) = \mathrm{mod}\left(V_{i,j}^{(i_{LS})}, Z\right)$, for each i and j. (For reference, in the 3GPP 5G standard specification TS 38.212, $V_{i,j}^{(i_{LS})}(Z)$ was simply expressed as $P_{i,j}$.)

As described in [Equation 11], it should be noted that, in the disclosure, no special transformation is applied to portions in the base matrix and the exponent matrix corresponding to a ZxZ zero matrix. For example, unless otherwise specified, in $V(\mathbf{H}_{i_{LS}}(Z)) = V(\mathbf{H}_{i_{LS}})$ (mod $Z$), no special transformation is performed on the portion corresponding to the zero matrix, and only the size of the zero matrix may vary depending on the value of Z. As a specific example, in the representation used in 3GPP 5G standard specifications, such as [Table 1] and [Table 2], because the portion corresponding to a ZxZ zero matrix is not indicated from the beginning, if a predefined transformation such as modulo is appropriately applied only to $V_{i,j}$ included in [Table 1] or [Table 2], the portion corresponding to the zero matrix is naturally left untransformed, which is equivalent to defining a zero matrix of a different size. The above representation method is merely one example for convenience of description, and various other representation methods may also exist.

For a given exponent matrix (or circulant shift value matrix), because the parity-check matrix or matrix-**H** may be transformed in various ways by lifting sizes defined in [Table 3], the set of required lifting sizes may be defined differently according to the system. For example, [Table 3] and [Table 4] are examples, and all lifting size Z values included in the [Table 3] and [Table 4] lifting size (or block size) group (or set) may be used, or some of appropriate lifting sizes may be selected and used according to the situation required by the system, and more various lifting size values may be added, as needed.

For example, in the case where the minimum value of the transport block size (TBS) is 24, Z = 2, 3, 4, 5, 6, 9, and 13 are practically not used in the system. In this case, the definition may exclude some Z values, as illustrated in [Table 5].

[Table 5]

| Set index ($i_{LS}$) | Set of lifting sizes (Z) |
|---|---|
| 0 | {8, 16, 32, 64, 128, 256} |
| 1 | {12, 24, 48, 96, 192, 384} |
| 2 | {10, 20, 40, 80, 160, 320} |
| 3 | {7, 14, 28, 56, 112, 224} |
| 4 | {18, 36, 72, 144, 288} |
| 5 | {11, 22,44, 88, 176, 352} |
| 6 | {26, 52, 104,208} |
| 7 | {15, 30, 60, 120, 240} |

In an LDPC code-based communication system that applies [Table 5] as the lifting size, because the minimum lifting size is 7, each column block that includes the parity-check matrix of the LDPC code used for LDPC encoding and decoding may include at least 7 columns.

For future scalability, the minimum value of the TBS is 8 or more, and in the case where additional values such as 8 or 16 are used, the lifting size set (or block size group) may be changed, as illustrated in [Table 6].

[Table 6]

| Set index ($i_{LS}$) | Set of lifting sizes (Z) |
|---|---|
| 0 | {4, 8, 16, 32, 64, 128, 256} |
| 1 | {6, 12, 24, 48, 96, 192, 384} |
| 2 | {(5,) 10, 20, 40, 80, 160, 320} |
| 3 | {7, 14, 28, 56, 112, 224} |
| 4 | {(9,) 18, 36, 72, 144, 288} |

(continued)

| Set index ($i_{LS}$) | Set of lifting sizes (Z) |
|---|---|
| 5 | {11, 22,44, 88, 176, 352} |
| 6 | {(13,) 26, 52, 104, 208} |
| 7 | {15, 30, 60, 120, 240} |

[Table 6] excludes only the cases in [Table 3] or [Table 4] where Z = 2 or 3, because when the TBS is 8 or more, the minimum value of Z that may be determined is 4 or more.

As an example of configuring another lifting size set, in the case where the lifting size set is classified into A sets $Z_1$, $Z_2$, $Z_3$, ..., $Z_A$, it may be basically classified in the following manner ($k$ = 1, 2, ...).

$$Z_1 = \{A, 2A, ..., 2^k A\}$$

$$Z_2 = \{(A + 1), 2(A + 1), ..., 2^k(A + 1)\}$$

...

$$Z_i = \{(A + i - 1), 2(A + i - 1), ..., 2^k(A + i - 1)\}$$

...

$$Z_A = \{2A - 1, 2(2A - 1), ..., 2^k(2A - 1)\}$$

For example, the following example for the case where A = 4 and A = 8 may be expressed as in [Table 7-1] and [Table 7-2] ($k$ = 0, 1, 2, ...).

[Table 7-1]

| Set of lifting sizes (Z) |
|---|
| 4, 8, 16, 32, ... (= 4 × $2^k$) |
| 5, 10, 20, 40, ... (= 5 × $2^k$) |
| 6, 12, 24, 48, ... (= 6 × $2^k$) |
| 7, 14, 28, 56, ... (= 7 × $2^k$) |

[Table 7-2]

| Set of lifting sizes (Z) |
|---|
| 8, 16, 32, 64, ... (= 8 × $2^k$) |
| 9, 18, 36, 72, ... (= 9 × $2^k$) |
| 10, 20, 40, 80, ... (= 10 × $2^k$) |
| 11, 22, 44, 88, ... (= 11 × $2^k$) |
| 12, 24, 48, 96, ... (= 12 × $2^k$) |
| 13, 26, 52, 108, ... (= 13 × $2^k$) |
| 14, 28, 56, 112, ... (= 14 × $2^k$) |
| 15, 30, 60, 120, ... (= 15 × $2^k$) |

In the case where the lifting size sets are defined in the manner illustrated in [Table 7-1] and [Table 7-2], there is an advantage that the distribution of Z values may be configured relatively uniformly. Although the lifting size sets defined in [Table 7-1] and [Table 7-2] include the same number of Z values, appropriate Z values may be added to or removed from each set as needed. For example, it is possible to define the lifting size sets of [Table 3] to [Table 6] based on the lifting size sets of [Table 7-2].

In [Table 7-1] and [Table 7-2], by appropriately configuring the range of k values, Z values suitable for the system may also be configured. For example, when k value is configured to $k = 0,1, ..., 6$, 7 lifting size sets with the number of different Z values are obtained in each set, and when k value is configured to $k = 3, 4, ... , 6$, 4 lifting size sets with the number of different Z values are obtained in each set. However, the $k$ value is an example, and an example of the $k$ value does not limit the scope of the rights of the disclosure. In some cases, appropriate Z values may be added or excluded in the lifting size sets. For example, if the maximum value of Z configured in the system is Zmax, all values greater than Zmax may be removed (e.g., Zmax = 768). In the existing 3GPP 5G standard, in the case where all supportable Z values are included, at least some of values such as 2, 3, 4, 5, 6, and 7 may be further included. In a 5G or 6G system, even if values such as TBS = 8, 16 are additionally supported, values such as Z = 2, 3 are not used; thus, only values such as 4, 6, 7 or 4, 5, 6, 7 may be further included, and values that are not actually used in 5G may be excluded. [Table 8] illustrates specific examples of lifting size sets (In Table 8, the numbers in () indicate values that may or may not be used as lifting sizes.).

[Table 8]

| Set index ($i_{LS}$) | Set of lifting sizes (Z) |
|---|---|
| 0 | {(2, 4,) 8, 16, 32, 64, 128, 256, 512} |
| 1 | {(3, 6,) 12, 24, 48, 96, 192, 384, 768} |
| 2 | {(5,) 10, 20, 40, 80, 160, 320, 640} |
| 3 | {7, 14, 28, 56, 112, 224, 448(, 896)} |
| 4 | {(9,) 18, 36, 72, 144, 288, 576} |
| 5 | {11, 22, 44, 88, 176, 352, 704} |
| 6 | {(13,) 26, 52, 104, 208, 416(, 832)} |
| 7 | {15, 30, 60, 120, 240, 480(, 960)} |

In a new communication system including a 6G system, in order to support backward compatibility with an existing system (e.g., 5G system), the existing lifting size set may be maintained as it is (e.g., [Table 3] or [Table 4]), and a new lifting size set may be added (e.g., [Table 5] to [Table 8]). A lifting size set may be defined as a single set, but if the range of TBS to be used is predetermined differently according to the application scenario or system configuration, such as the target BLER, the range of Z values to be used also varies. For example, if a first minimum TBS and a first maximum TBS values are configured for a service applying a first target BLER, and a second minimum TBS and/or a second maximum TBS values are defined for a service applying a second target BLER, the first minimum TBS and the second minimum TBS values may be different, or the first maximum TBS and the second maximum TBS values may be different (both the minimum and maximum values may be different).

The applicable service scenario or target BLER, and the like may be determined based on upper layer signaling information. For example, the CQI table or MCS table may be commonly determined by considering the target service scenario or BLER. (e.g., a first target service or BLER may be determined by considering a first CQI table and/or a first MCS table, a second target service or BLER may be determined by considering a second CQI table and/or a second MCS table, and a third party target service or BLER may be determined by considering a third party CQI table and/or a third MCS table, etc.)

This may refer, for example, to the range of lifting sizes to be used, or the set of lifting sizes to be used, being determined from upper layer signaling information, and the intermediate operations may exist in various manners according to the system. The set of lifting sizes to be used may be indicated through physical layer signaling or upper layer signaling. A parity-check matrix may be determined based on the indicated set of lifting sizes and the determined lifting size Z value.

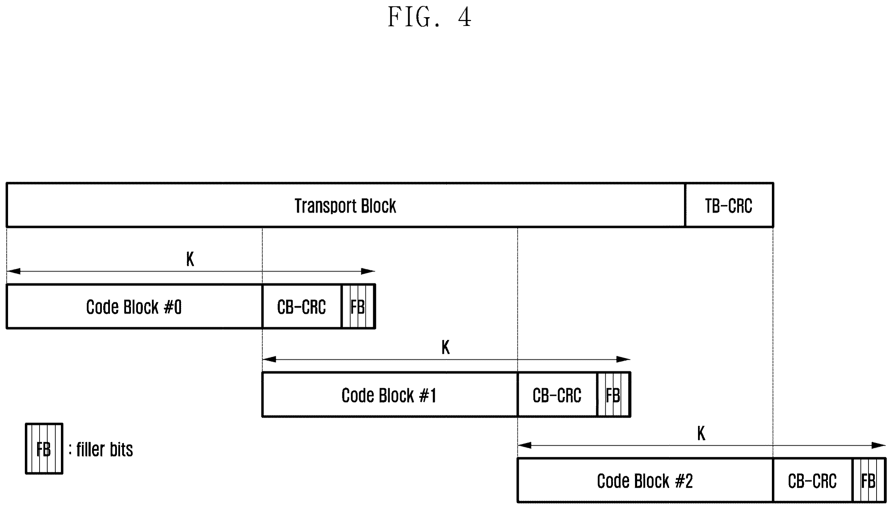

FIG. 4 is a diagram illustrating an example transport block structure according to various embodiments.

With reference to FIG. 4, CRC bits (TB-CRC bits) of L bits are added to a transport block including A bits, and a single transport block may become a single code block. In the case where the value B = A + L is greater than a specific threshold, the transport block may be divided into multiple code blocks through an appropriate segmentation process. In this case, all code blocks have the same K size, and for this purpose, specific bits called null bits or filler bits may be added to each code block. These null bits or filler bits typically have a value of 0, but are not necessarily limited to that, and may include other predetermined bit values. This operation of adding predetermined bits such as null bits or filler bits reduces the size of actual pure information bits and is commonly referred to as shortening, and in the case where values of added bits are 0, the operation may also be referred to as zero-padding.

After the size of the transport block to be transmitted (transport block size (TBS)) is determined, one of two different base matrices of LDPC codes used for LDPC encoding or decoding may be determined based on the TBS size and the code rate indicated by the MCS through a method such as a [base matrix determination method] described below.

**[Base matrix determination method]**

The LDPC base matrix for LDPC encoding and decoding of a transport block with TBS = A may be determined based on the TBS size and the code rate indicated by the MCS as follows:

- If $A \leq 292$ (or 288), or $A \leq 3824$ and $R \leq 0.67$ or $R \leq 0.25$, LDPC encoding may be performed using LDPC base matrix 2.
- Otherwise, LDPC encoding may be performed using LDPC base matrix 1. For reference, the base matrix 1 $M(\mathbf{H}_{BG1})$ and the base matrix 2 $M(\mathbf{H}_{BG2})$ defined in the 3GPP 5G standard are as follows.

$M(\mathbf{H}_{BG1})$:

```
0 1 2 3 5 6 9 10 11 12 13 15 16 18 19 20 21 22 23
0 2 3 4 5 7 8 9 11 12 14 15 16 17 19 21 22 23 24
0 1 2 4 5 6 7 8 9 10 13 14 15 17 18 19 20 24 25
0 1 3 4 6 7 8 10 11 12 13 14 16 17 18 20 21 22 25
0 1 26
0 1 3 12 16 21 22 27
0 6 10 11 13 17 18 20 28
014781429
0 1 3 12 16 19 21 22 24 30
0 1 10 11 13 17 18 20 31
1 2 4 7 8 14 32
0 1 12 16 21 22 2333
0 1 10 11 13 18 34
0 3 7 20 23 35
0 12 15 16 17 21 36
0 1 10 13 18 25 37
1 3 11 20 22 38
0 14 16 172139
1 12 13 18 1940
0 1 7 8 10 41
0 3 9 11 22 42
1 5 16 20 21 43
0 12 13 1744
1 2 10 18 45
0 3 4 11 22 46
1 6 7 14 47
0 2 4 15 48
16849
0 4 19 21 50
1 14182551
0 10 13 24 52
1 7 22 25 53
0 12 14 24 54
1 2 11 21 55
0 7 15 17 56
1 6 12 22 57
0 14 15 18 58
1 13 23 59
0 9 10 12 60
1 3 7 19 61
0 8 17 62
1 3 9 18 63
```

042464
1 16 182565
0792266
161067

$M(\mathbf{H}_{BG2})$:

0123691011
0 3 4 5 6 7 8 9 11 12
0 1 3 4 8 10 12 13
1 2 4 5 6 7 8 9 10 13
0 1 11 14
0 1 5 7 11 15
0 5 7 9 11 16
157111317
0 1 12 18
1 8 10 11 19
0 16720
0 7 9 13 21
1 3 11 22
0 1 8 13 23
1 6 11 13 24
0 10 11 25
1 9 11 12 26
1 5 11 12 27
06728
0 1 10 29
1 4 11 30
081331
1232
0 3 5 33
12934
0535
2 7 12 13 36
0637
12538
0439
2 5 7 9 40
1 13 41
05 1242
2 7 10 43
0 12 13 44
1 5 11 45
0 2 7 46
10 13 47
1 5 11 48
07 1249
2 10 13 50
1 5 11 51

Sizes of the base matrix 1 $M(\mathbf{H}_{BG1})$ and the base matrix 2 $M(\mathbf{H}_{BG2})$ are 46×68 and 42×52, respectively, and sizes of the parity-check matrix derived from the base matrices are 46Z×68Z and 42Z×52Z, respectively.

Further, the number $L_{TB}$ of CRC bits to be added to the transport block may be determined as follows according to the above-determined TBS.

[Method of determining number of transport block CRC bits]

A CRC bit size $L_{TB}$ value for a transport block with TBS = A may be configured differently according to the TBS value as follows.

If A > 3824, then $L_{TB}$ is set to 24; otherwise, $L_{TB}$ is set to 16.

Depending on the TBS size (A) determined in this way, or the total number of bits B = A + L including the CRC appended to the transport block, appropriate code blocks may be determined from the transport block, and LDPC encoding and decoding may be performed for each code block. In this case, a process of determining the code block size (CBS) is described in more detail as follows:

**[Method of determining CBS]**

The input bit sequence for code block segmentation may be represented as $b_0, b_1. ..., b_{B-1}$ (B > 0). If B is greater than the maximum code block size $K_{cb}$, the input bit sequence is segmented, and a 24-bit CRC (L = 24) is additionally appended to each code block. The maximum code block size $K_{cb}$ is 8448 for LDPC base matrix 1, and the maximum code block size $K_{cb}$ is 3840 for LDPC default matrix 2.

Various example steps are described as follows.

Step 1: The number *C* of code blocks may be determined.

- If $B \leq K_{cb}$, then *L* = 0, *C* = 1, and *B' = B*.

- otherwise, *L* = 24, $C = \left\lceil B/(K_{cb} - L) \right\rceil$, and *B' = B + C × L*.

Step 2: When bit outputs from the code block segmentation are denoted as $c_{r0}, c_{r1},..., cr_{(Kr-1)}$, r denotes the code block number ($0 \leq r < C$), and Kr (= K) denotes the number of bits in the code block corresponding to code block number r. Here, K, the number of bits included in each code block, may be calculated as follows:

-

$$K' = B'/C;$$

- For LDPC base matrix 1, $K_b$ = 22.
- For LDPC base matrix 2,

  If *B* > 640, then $K_b$ = 10;
  If 560 < *B* $\leq$ 640, then $K_b$ = 9;
  If 192 < *B* $\leq$ 560, then $K_b$ = 8;
  If *B* $\leq$ 192, then $K_b$ = 6.

Step 3: The minimum value $Z_c$ that satisfies $K_b \cdot Z \geq K'$ among *Z* values in Table 3 may be determined. For LDPC base matrix 1, $K = 22Z_c$, and for LDPC base matrix 2, $K = 10Z_c$.

The $K_b$ value in step 2 of the above [CBS Determination Method] is a value corresponding to each column or column block corresponding to LDPC information bits in the base matrix (or base graph) or the parity-check matrix of the LDPC code and may correspond to the maximum value (= $K_bZ_c$) of LDPC information bits without shortening or zero padding. For example, even if the number of columns (or column blocks) corresponding to the information bits in LDPC base matrix 2 or the parity-check matrix corresponding to base matrix 2 is 10, if $K_b$ is set to 6, then LDPC encoding/decoding is substantially performed on the maximum $6Z_c$ information bits, and the information bits corresponding to at least (10 - $K_b)Z_c = 4Z_c$ columns in the parity-check matrix are shortened or zero-padded. Here, shortening or zero padding may refer, for example, to the transmitter and the receiver assigning predetermined bit values such as 0 and that the corresponding portions of the parity-check matrix are not used.

The lifting size *Z* value for LDPC encoding and decoding may be determined based on the lifting size sets illustrated in [Table 3] to [Table 8], or lifting size sets with specific values added and removed. Each Z value is included in a predetermined specific set according to the index $i_{LS}$, and when the Z value is determined in step 3 of [CBS Determination Method], the set corresponding to the Z value or the index $i_{LS}$ value of the set is also determined, and the parity-check matrix of the LDPC code corresponding to each index or the corresponding sequence may also be determined. By applying a modulo operation based on the lifting size Z to the parity-check matrix of the LDPC code determined in this way or the corresponding sequence, the parity-check matrix or sequence is transformed to support encoding and decoding of LDPC codes of various lengths. In the 3GPP 5G standard, each number included in the parity-check matrix or sequence of an LDPC code represents a value corresponding to a circulant permutation matrix.

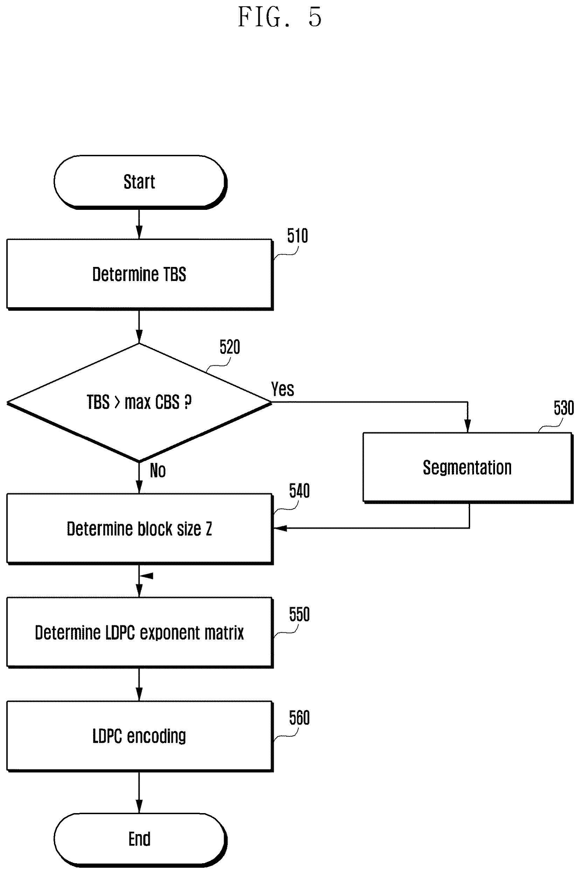

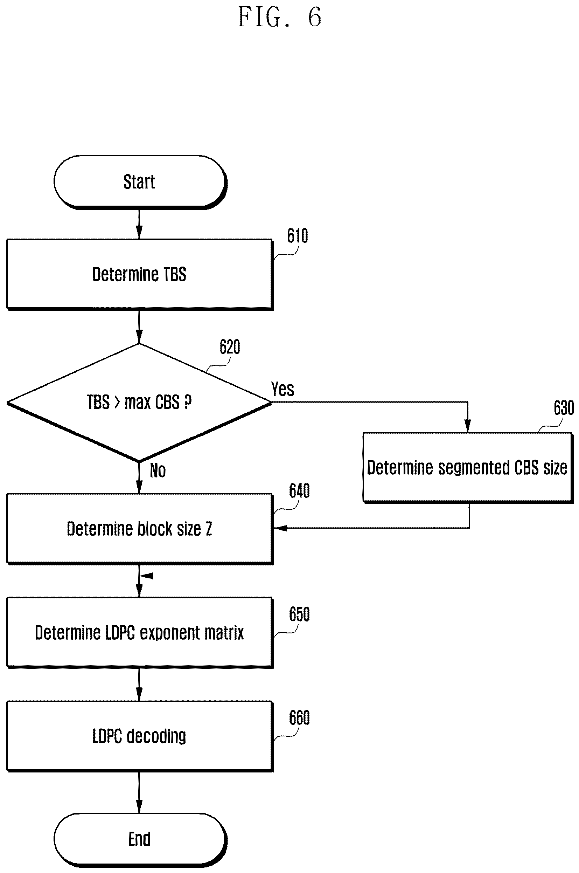

Flowcharts illustrating an example embodiment of an LDPC encoding and decoding process based on a designed base matrix or exponent matrix are illustrated in FIGS. 5 and 6.

FIG. 5 is a flowchart illustrating an example LDPC encoding process according to various embodiments.

The transmitter determines a transport block size TBS to be transmitted, as in step 510 of FIG. 5. At step 520, the transmitter determines whether the TBS is greater than, less than, or equal to a max CBS.

If the TBS is greater than a max CBS, the transmitter may segment the transport block to determine a CBS at step 530. If the TBS is less than or equal to a max CBS, the transmitter skips a segmentation operation and determines the TBS as the CBS.

At step 540, the transmitter determines a lifting size value Z to be applied to LDPC encoding based on the CBS.

At step 550, the transmitter determines a parity-check matrix or sequence according to the TBS, CBS, or lifting size Z value. The transmitter may determine an LDPC exponent matrix or sequence that has an algebraically equivalent effect to the parity-check matrix.

At step 560, the transmitter performs LDPC encoding based on the parity-check matrix or sequence. At step 560, the transmitter may perform LDPC encoding based on the exponent matrix or sequence. At step 560, the transmitter may perform LDPC encoding based on the lifting size and the exponent matrix or sequence.

For reference, step 550 may include, in some cases, a process of transforming the determined LDPC exponent matrix or sequence based on the determined lifting size. It is evident that the LDPC exponent matrix, sequence, or parity-check matrix for LDPC encoding may be determined in various manners according to the system, based on the TBS or CBS. For example, the transmitter may first determine a base matrix through the TBS, and then determine an LDPC exponent matrix, sequence, or parity-check matrix based on the determined base matrix and the CBS, and other various methods may also be applied. For reference, according to the system, additional operations may be included between step 520 and step 540, or between step 530 and step 540, and for example, in the case of a 3GPP 5G system, when base matrix 2 ($M(\mathbf{H_{BG2}})$) is used, a process of determining a $K_b$ value indicating the number of columns to be actually used in the base matrix or the number of column blocks to be used in the parity-check matrix, according to the TBS size may be included. (For reference, column blocks in the parity-check matrix corresponding to the (10 - $K_b$) columns of the base matrix are shortened.)

The LDPC decoding process may be similarly represented as in FIG. 6.

FIG. 6 is a flowchart illustrating an example LDPC decoding process according to various embodiments.

If the TBS is determined at step 610, the receiver determines at step 620 whether the TBS is greater than, less than, or equal to the max CBS.

If the TBS is greater than the max CBS, the receiver determines, at step 630, the size of the CBS to which segmentation is applied. If the TBS is less than or equal to the max CBS, the TBS is determined to be equal to the CBS.

At step 640, the receiver determines the lifting size Z value to be applied to LDPC decoding.

At step 650, the receiver determines a parity-check matrix or sequence according to the TBS, CBS, or lifting size Z value. The transmitter may determine an exponent matrix or sequence that has an algebraically equivalent effect to the parity-check matrix.

At step 660, the receiver may perform LDPC decoding based on a parity-check matrix or sequence. At step 660, the receiver may perform LDPC decoding using an exponent matrix or sequence. For reference, step 650 may include, in some cases, a process of transforming the determined LDPC exponent matrix or sequence based on the determined lifting size. It is evident that the LDPC exponent matrix, sequence, or parity-check matrix for LDPC decoding may be determined in various ways based on the TBS or CBS according to the system. For example, the receiver may first determine a base matrix through the TBS, and then determine the LDPC exponent matrix, sequence, or parity-check matrix based on the determined base matrix and the CBS, and other various methods may also be applied.

According to the above embodiment, the process of determining the exponent matrix or sequence of the LDPC code in steps 550 and 650 of FIGS. 5 and 6 has been described based on the case where the exponent matrix or sequence is determined by one of the TBS, CBS, or lifting size Z, but various other methods may exist. Further, according to the system, additional operations may be included between steps 620 and 640 or between steps 630 and 640 of FIG. 6, for example, in a 3GPP 5G system, when base matrix $2M(\mathbf{H_{BG2}})$ is used, a process of determining the value of $K_b$ indicating the number of columns to be actually used in the base matrix, or the number of column blocks to be used in the parity-check matrix according to the TBS size may be included. For reference, because the receiver may infer that bits corresponding to the column blocks in the parity-check matrix corresponding to the (10 - $K_b$) columns of the base matrix have been shortened at the transmitter, the receiver may additionally perform appropriate operations on the shortened bits before LDPC decoding.

In an embodiment of the LDPC encoding and decoding process based on the base matrix and exponent matrix (or LDPC sequence) of the LDPC code of FIGS. 5 and 6, LDPC encoding and decoding of various code rates and lengths may be supported by appropriately shortening or puncturing some of the information bits of the LDPC code, and by puncturing and repeating some of the codeword bits. For example, as in the 3GPP 5G standard technology, by applying shortening to part of information bits during the LDPC encoding process of FIG. 5, puncturing information bits corresponding to the first two columns of the base matrix, e.g., the first 2Z columns of the parity-check matrix, and by puncturing some of the parity bits or repeating some of the LDPC codeword, it is possible to support various information word lengths (or code block lengths) and code rates.

When the given input bits or code block bits are denoted as $i_0$, $i_1$, $i_2$, ... , $i_{K-1}$ and the encoding bits are denoted as $d_0$, $d_1$, $d_2$, ... , $d_{N-1}$ (where $N = 66Z$ for base matrix 1, and $N = 50Z$ for base matrix 2), a portion of the encoding process may be defined as illustrated in [Table 9].

[Table 9]

$$\text{for } k = 2Z \text{ to } K - 1$$

$$\text{if } i_k \neq <NULL>$$

$$d_{k-2Z_c} = i_k;$$

$$\text{Else}$$

$$i_k = 0;$$

$$d_{k-2Z_c} = <NULL>;$$

$$\text{end if}$$

$$\text{end for}$$

According to the above encoding process, the first 2Z bits, $i_0$, $i_1$, $i_2$, ... , $i_{2Z-1}$, of the input bits or code block bits are not included in the coded bits. For example, these 2Z bits are punctured at the transmitter and are not transmitted to the receiver. For reference, in the case where part of the information bits is punctured, the transmitter does not transmit a portion of the information word 102 of FIG. 1; therefore, the receiver may treat the untransmitted information bits as erasures and perform decoding accordingly. In other words, the punctured bits are regarded as lost bits, and because they have equal probability of being 0 or 1, the receiver may perform decoding by inserting corresponding values.

The information bits punctured during the encoding process may not always be transmitted, even in the case of retransmission. In the case where a circular buffer is used for rate matching, if rate matching and retransmission are performed without storing the punctured information bits in the circular buffer, the punctured information bits may not always be transmitted.

In the case of a first transmission, some of the information bits may be punctured, and in the case of a retransmission, all or part of the punctured information bits may be transmitted. All information bits are stored in a circular buffer, but in the case of the first transmission, a redundancy value (RV) may be appropriately configured so that some information bits are punctured (e.g., an RV0 value may be configured to exclude information bits to be punctured). Even if some information bits are punctured during the first transmission, the bit values remain stored in the circular buffer; thus, in the case of a retransmission, some or all of the punctured information bits may be transmitted according to the circular buffer rate matching operation and selection of an appropriate RV value.

In [Table 9], for convenience, $d_0$, $d_1$, $d_2$, ... , $d_{N-1}$ is referred to as the coded bit sequence, but the definition of coding bits may vary for convenience of description. For example, as illustrated in [Table 9], $d_0$, $d_1$, $d_2$, ... , $d_{N-1}$, the bit sequence after puncturing part of the information bits may be defined as the coded bit sequence, but because the input bits or code block bits $i_0$, $i_1$, $i_2$, ... , $i_{K-1}$ are actually used to generate the parity bit vector $\underline{w}$ during the coding process, $(\underline{i}, \underline{w}) = (i_0, i_1, i_2, ... , i_{K_{ldpc}-1}, w_0, w_1, w_2, ... , w_{N_{ldpc}-K_{ldpc}-1})$ may also be defined as the coded bit sequence based on the information bits before puncturing.

A bit sequence $e_0$, $e_1$, $e_2$, ... , $e_{E-1}$, to which rate matching is applied based on the allocated resource amount, may be defined as the coded bit sequence, and a bit sequence $f_0$, $f_1$, $f_2$, ... , $f_{E-1}$, to which interleaving is applied to a rate-matched bit sequence, may also be defined as the coded bit sequence. Further, the coded bit sequence may be defined in various ways for convenience of description, but typically, the bit sequence actually related to transmission in the system is represented as $d_0, d_1, d_2, ... , d_{N-1}$, but ($\underline{i}, \underline{w}$) related to the coding process may also be defined as coded bits.

In the LDPC decoding process of FIG. 6, decoding may be performed by adding appropriate operations for shortened information bits, punctured bits, or repeated bits, in response to the transmitter's operations. Because the shortened information bits are 0, the receiver performs decoding by excluding columns corresponding to shortened bits from the parity-check matrix, or performs decoding by configuring preconfigured values in the system to shortened bits. (Because these bits are known to be 0, the system commonly configures the highest value corresponding to 0.) Because the punctured parity bits are treated as erasures with equal probability of being 0 and 1, the receiver may perform decoding by inserting corresponding values, or according to the structure of the parity-check matrix, the receiver may perform decoding without using at least some of rows corresponding to the punctured parity bits. In general, when puncturing a parity bit corresponding to a column of degree 1, the LDPC decoder may perform decoding without using some or all of corresponding parts of the parity-check matrix, which has the advantage of reducing decoding complexity.

When supporting a variable information word length or variable code rate using shortening or zero padding of LDPC codes, the code performance may be improved according to the shortening order or shortening method. If a shortening order is configured, the encoding performance may be enhanced by appropriately rearranging the order of some or all of the given base matrix. For a specific information word length (or code block length (CBS)), the performance may also be improved by appropriately determining the number of column blocks to which the lifting size or shortening is applied. Similarly, there is a method to improve the performance of LDPC codes by adjusting the puncturing order of parity bits or the transmission order of the generated LDPC codeword. For example, better performance may be supported by appropriately puncturing some information bits and parity bits, rather than simply puncturing the parity bits to support a variable code rate. Further, when repeating part of an LDPC codeword in order to support a lower code rate, the LDPC encoding performance may be improved by determining the repetition order appropriately in advance.

In the LDPC encoding process, the transmitter may first determine the size of input bits (or code blocks) to which the LDPC encoding is to be applied, and then determine the lifting size Z to which the LDPC encoding is to be applied based on the size, determines an appropriate LDPC exponent matrix or sequence based on the lifting size, and then performs LDPC encoding based on the lifting size Z and the determined exponent matrix or LDPC sequence. In this case, the LDPC exponent matrix or sequence may be applied to LDPC encoding without transformation, or in some cases, the LDPC exponent matrix or sequence may be appropriately transformed according to the lifting size Z to perform LDPC encoding.

Similarly, in the LDPC decoding process, the receiver determines the size of input bits (or code blocks) for the transmitted LDPC codeword, and then determines a lifting size Z to be applied for LDPC decoding based on the size, determines an appropriate LDPC exponent matrix or sequence based on the lifting size, and then performs LDPC decoding based on the lifting size Z and the determined exponent matrix or LDPC sequence. In this case, the LDPC exponent matrix or sequence may be applied to LDPC decoding without any transformation, and in some cases, the LDPC exponent matrix or sequence may be appropriately transformed according to the lifting size Z to perform LDPC decoding.

In a parity-check matrix, a submatrix corresponding to the parity bit often has a special structure to enable efficient encoding. In such cases, lifting may change the encoding method or the complexity. Therefore, in order to maintain the same encoding method or complexity, lifting may either not be applied to part of the exponent matrix corresponding to the parity submatrix of the parity-check matrix, or a different lifting method may be applied to it compared to that applied to the exponent matrix corresponding to the submatrix for the information bits. In other words, the lifting method applied to the sequence corresponding to the information bits in the exponent matrix and the lifting method applied to the sequence corresponding to the parity bits may be configured differently, and in some cases, lifting may not be applied to some or all of sequences corresponding to the parity bits, and a fixed value may be used without sequence transformation.

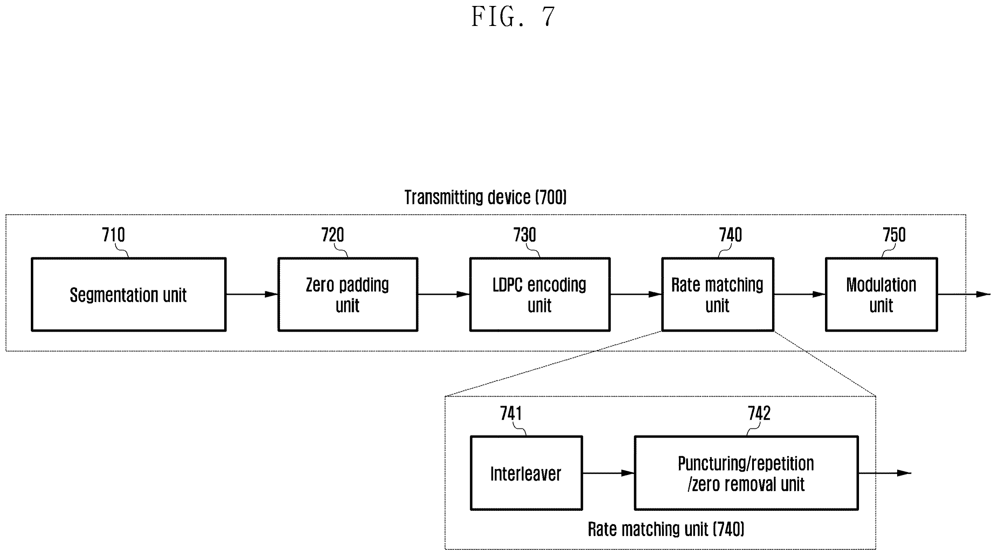

FIG. 7 is a block diagram illustrating an example configuration of a transmitting device according to various embodiments.

As illustrated in FIG. 7, a transmitting device 700 may include a segmentation unit 710, a zero padding unit 720, an LDPC encoding unit 730, a rate matching unit 740, and a modulation unit 750 in order to process variable-length input bits. The rate matching unit 740 may include an interleaver 741 and a puncturing/repetition/zero removal unit 742.

The components illustrated in FIG. 7 are components for performing encoding and modulation for variable-length input bits, and this is merely one example, and in some cases, some of the components illustrated in FIG. 7 may be omitted or modified, and other components may be added.

The transmitting device 700 may determine necessary parameters (e.g., at least one of input bit length, modulation and code rate (ModCod), parameters for zero padding (or shortening), code rate or codeword length of the LDPC code, parameters for interleaving, repetition, or puncturing, or modulation schemes), and encode input bits based on the determined parameters and transmit them to a receiving device 800.

Because the number of input bits is variable, in the case where the number of input bits is greater than a preconfigured value, the input bits may be segmented to have a length less than or equal to the preconfigured value. Further, each segmented block may correspond to one LDPC-coded block. However, in the case where the number of input bits is less than or equal to a preconfigured value, the input bits are not segmented and the input bits may correspond to a single LDPC-coded block.

The transmitting device 700 may store various parameters used for encoding, interleaving, and modulation. The parameters used for encoding may include at least one of a code rate, a codeword length, or information on a parity-check matrix of the LDPC code. The parameters used for interleaving may include information on an interleaving rule, and the parameters used for modulation may include information on a modulation scheme. Information on puncturing may include a puncturing length. Information on repetition may include a repetition length. The information on the parity-check matrix may include exponent values of circulant matrices or values algebraically equivalent thereto in the case where the parity matrix of the disclosure is used.

In this case, each component of the transmitting device 700 may perform an operation using these parameters.

Although it is not illustrated, in some cases, the transmitting device 700 may further include a controller (not illustrated) for controlling the operation thereof.

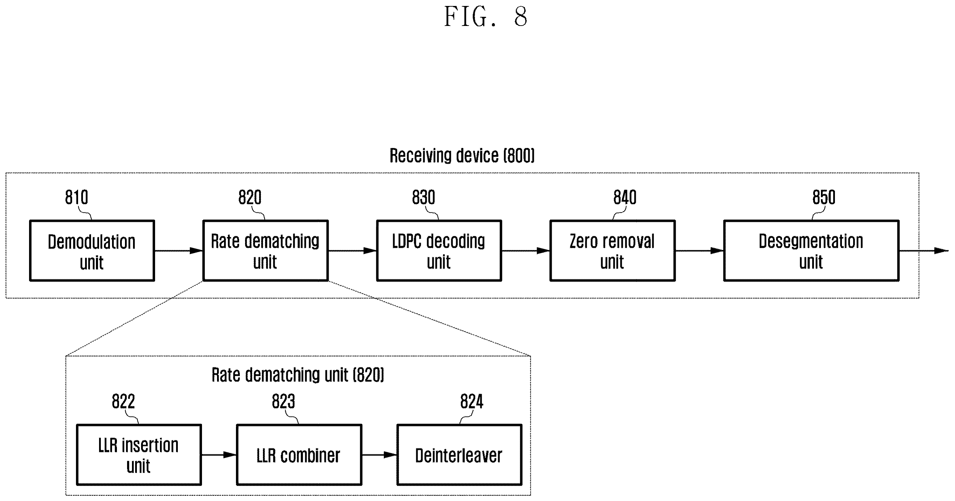

FIG. 8 is a block diagram illustrating an example configuration of a receiving device according to various embodiments.

As illustrated in FIG. 8, a receiving device 800 may include a demodulation unit 810, a rate dematching unit 820, an LDPC decoding unit 830, a zero removal unit 840, and a desegmentation unit 850 in order to process variable length information. The rate dematching unit 820 may include a log likelihood ratio (LLR) insertion unit 822, an LLR combiner 823, and a deinterleaver 824.

The components illustrated in FIG. 8 are components that perform functions corresponding to the components illustrated in FIG. 8, and this is merely one example, and some thereof may be omitted or modified according to the case, and other components may be added.

The parity-check matrix in the disclosure may be read using a memory, may be provided in advance to a transmitting device or a receiving device, or may be directly generated by the transmitting device or the receiving device. Further, the transmitting device may store or generate a sequence or an exponent matrix corresponding to the parity-check matrix, or a value algebraically equivalent thereto, and apply the same to encoding. Similarly, the receiving device may store or generate a sequence or an exponent matrix corresponding to the parity-check matrix, or a value algebraically equivalent thereto, and apply the same to decoding.

Hereinafter, a detailed description of the receiver operation is provided based on FIG. 8.

The demodulator 810 demodulates the signal received from the transmitting device 700.

For example, the demodulator 810 is a component corresponding to the modulation unit 750 of the transmitting device 700, and may demodulate a signal received from the transmitting device 700 to generate values corresponding to bits transmitted from the transmitting device 700.

To this end, the receiving device 800 determines parameters necessary for demodulation and decoding (e.g., at least one of input bit length, modulation and code rate (ModCod), parameters for zero padding (or shortening), code rate/codeword length of LDPC code, parameters for interleaving, or parameters for repetition and puncturing, or modulation schemes), and based on the determined parameters, the demodulation unit 810 may perform a decoding process of demodulating a signal received from the transmitting device 700 according to a mode and generating values corresponding to LDPC codeword bits.

The value corresponding to the bits transmitted from the transmitting device 700 may be a likelihood ratio (LR) value or a log likelihood ratio (LLR) value.

For example, the LR value refers to the ratio between the probability that the bit transmitted by the transmitting device 700 is 0 and the probability that it is 1, and the LLR value may be represented as the logarithm of the ratio between the probability that the bit transmitted by the transmitting device 700 is 0 and the probability that it is 1. The LR or LLR value may be hard-decided and expressed as the bit value itself, according to the probability, the probability ratio, or the logarithm of the probability ratio, or may be expressed as a predefined representative value according to the range to which the probability, the probability ratio, or the logarithmic probability ratio belongs. One example of a method of determining a predefined representative value according to the range to which the probability, the probability ratio, or the logarithm of the probability ratio belongs is a method that considers quantization. Further, various other values corresponding to the probability, the probability ratio, or the logarithmic probability ratio may be used.

In the disclosure, for convenience, an operation based on LLR values is illustrated to describe the operation of the receiving method and device, but the disclosure is not necessary limited thereto.

The demodulation unit 810 includes a function for performing multiplexing (not illustrated) on LLR values. For example, a multiplexer (not illustrated) is a component corresponding to a bit demultiplexer (not illustrated) of the transmitting device 700 and may perform an operation corresponding to the bit demultiplexer (not illustrated).

To this end, the receiving device 800 may store information on parameters that the transmitting device 700 used for demultiplexing and block interleaving. Accordingly, the multiplexer (not illustrated) may reverse the demultiplexing and block interleaving operations that were performed by the bit demultiplexer (not illustrated) on the LLR values corresponding to the cell words (e.g., information representing received symbols for LDPC codewords as vector values), and multiplex the LLR values corresponding to the cell words on a bit-by-bit basis.

The rate dematching unit 820 may additionally insert LLR values into the LLR values output from the demodulation unit 810. In this case, the rate dematching unit 820 may insert predetermined LLR values into the LLR values output from the demodulation unit 810.

For example, the rate dematching unit 820 is a component corresponding to the rate matching unit 740 of the transmitting device 700, and may perform operations corresponding to the interleaver 741, zero removal, and puncturing/repetition/zero removal unit 742.

The rate dematching unit 820 performs deinterleaving to correspond to the interleaver 741 of the transmitter. The LLR insertion unit 822 may insert LLR values corresponding to zero bits into positions where zero bits were padded in the LDPC codeword in the output values of the deinterleaver 824. In this case, the LLR values corresponding to the padded zero bits, e.g., the shortened zero bits, may be ∞ or -∞. However, ∞ or -∞ is a theoretical value, and in practice, it may be the maximum or minimum value of the LLR value used in the receiving device 800.

To this end, the receiving device 800 may store information on the parameters that the transmitting device 700 used for padding zero bits. Accordingly, the rate dematching unit 820 may determine the position where zero bits were padded in the LDPC codeword and insert an LLR value corresponding to the shortened zero bits at that position.

The LLR insertion unit 822 of the rate dematching unit 820 may insert LLR values corresponding to the punctured bits into positions of the punctured bits in the LDPC codeword. In this case, the LLR values corresponding to the punctured bits may be 0 or another predetermined value. In general, in the case where parity bits with degree 1 are punctured, there is no effect on improving the performance of the LDPC decoding process; thus, they may not be used in the LDPC decoding process without inserting LLRs into some or all of the corresponding punctured positions. However, in order to increase the efficiency of the LDPC decoding process based on parallel processing, the LLR insertion unit 822 may insert predetermined LLR values into positions corresponding to some or all of the punctured bits with degree 1, regardless of improvement on decoding performance.

To this end, the receiving device 800 may store information on parameters used for puncturing in the transmitting device 700. Accordingly, the LLR insertion unit 822 may insert a corresponding LLR value (e.g., LLR = 0) into punctured positions of the LDPC information bits or parity bits. However, this process may be omitted at some positions of the punctured parity bits.

The LLR combiner 823 may combine, e.g., add, LLR values output from the LLR insertion unit 822 and the demodulation unit 810. Specifically, the LLR combiner 823 is a component corresponding to the puncturing/repetition/zero removal unit 742 of the transmitting device 700 and may perform an operation corresponding to the repetition unit 742. The LLR combiner 823 may combine LLR values corresponding to repeated bits with other LLR values. The other LLR values may be LLR values for bits served as the basis for generating the repeated bits in the transmitting device 700, e.g., the LDPC information bits or parity bits that were selected as repetition targets.

As described above, the transmitting device 700 selects LDPC encoded bits, repeats them between LDPC information bits and LDPC parity bits, and transmits them to the receiving device 800. Accordingly, LLR values for the LDPC encoded bits may include an LLR value for repeated LDPC encoded bits and an LLR value for non-repeated LDPC encoded bits. The LLR combiner 823 may combine LLR values for the same LDPC encoded bits.

To this end, the receiving device 800 may store information on parameters used for repetition in the transmitting device 700. Accordingly, the LLR combiner 823 may determine LLR values for repeated LDPC encoded bits and combine them with LLR values for LDPC encoded bits served as the basis for the repetition.

The LLR combiner 823 may combine LLR values corresponding to retransmitted or incremental redundancy (IR) bits with other LLR values. Here, the other LLR values may be LLR values for some or all of LDPC codeword bits served as the basis for generating retransmitted or IR bits in the transmitting device 700.

As described above, in the case where a NACK occurs for HARQ, the transmitting device 700 may transmit some or all of codeword bits to the receiving device 800.

Accordingly, the LLR combiner 823 may combine LLR values for bits received through retransmission or IR with LLR values for LDPC codeword bits received through the previous frame.

To this end, the receiving device 800 may store information on parameters used by the transmitting device 700 for retransmission or for generating IR bits. Accordingly, the LLR combiner 823 may determine LLR values corresponding to the number of the retransmitted or IR bits and combine them with LLR values for LDPC encoded bits served as the basis for generating the retransmitted bits.

The deinterleaver 824 may deinterleave the LLR value output from the LLR combiner 823.

For example, the deinterleaver 824 is a component corresponding to the interleaver 741 of the transmitting device 700 and may perform an operation corresponding to the interleaver 741.

To this end, the receiving device 800 may store information on parameters that the transmitting device 700 used for interleaving. Accordingly, the deinterleaver 824 may reverse the interleaving operation performed by the interleaver 741 on the LLR values corresponding to the transmitted LDPC coded bits, thereby deinterleaving the LLR values corresponding to the transmitted LDPC coded bits.

The LDPC decoding unit 830 may perform LDPC decoding based on the LLR value output from the rate dematching unit 820.

For example, the LDPC decoding unit 830 is a component corresponding to the LDPC encoding unit 730 of the transmitting device 700 and may perform an operation corresponding to the LDPC encoding unit 730.

To this end, the receiving device 800 may store information on parameters that the transmitting device 700 used to perform LDPC encoding according to the mode. Accordingly, the LDPC decoding unit 830 may perform LDPC decoding based on the LLR values output from the rate dematching unit 820 according to the mode.

For example, the LDPC decoding unit 830 may perform LDPC decoding based on the LLR value output from the rate dematching unit 820 based on an iterative decoding method based on a sum-product algorithm, and output bits whose errors are corrected according to LDPC decoding. The LDPC decoding unit 830 may perform LDPC decoding for an LDPC codeword based on a parity-check matrix or an exponent matrix or sequence corresponding thereto. Further, the LDPC decoding unit 830 may perform LDPC decoding using a parity-check matrix defined differently according to the code rate (e.g., the code rate of the LDPC code). The LDPC decoding unit 830 may perform LDPC decoding by passing LLR values corresponding to the LDPC codeword bits through an iterative decoding algorithm to generate information bits. Here, the LLR values are channel values corresponding to the LDPC codeword bits and may be represented in various ways.

The zero removal unit 840 may remove zero bits from bits output from the LDPC decoding unit 830.

For example, the zero removal unit 840 is a component corresponding to the zero padding unit 720 of the transmitting device 700 and may perform an operation corresponding to the zero padding unit 720.

To this end, the receiving device 800 may store information on parameters used for padding zero bits in the transmitting device 700. Accordingly, the zero removal unit 840 may remove zero bits that were padded in the zero padding unit 720 from bits output from the LDPC decoding unit 830.

The desegmentation unit 850 is a component corresponding to the segmentation unit 710 of the transmitting device 700 and may perform an operation corresponding to the segmentation unit 710.

To this end, the receiving device 800 may store information on parameters that the transmitting device 700 used for segmentation. Accordingly, the desegmentation unit 850 may restore bits before segmentation by combining bits output from the zero removal unit 840, e.g., segments for variable-length input bits.

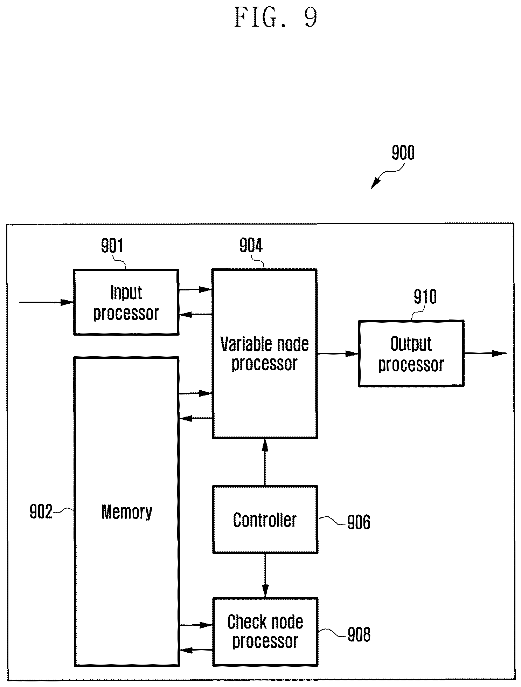

FIG. 9 is a block diagram illustrating an example configuration of an LDPC decoding unit according to various embodiments.

As described above, the LDPC decoding unit 830 may perform LDPC decoding using an iterative decoding algorithm, and in this case, the LDPC decoding unit 830 may include a structure as illustrated in FIG. 9. However, the configuration illustrated in FIG. 9 is merely one example.

With reference to FIG. 9, a decoding device 900 includes an input processor 901, a memory 902, a variable node processor 904, a controller 906, a check node processor 908, and an output processor 910.

The input processor 901 stores the input value. For example, the input processor 901 may store an LLR value of the received signal received through the channel.

The controller 904 determines the number of values input to the variable node processor 904 and an address value in the memory 902, and the number of values input to the check node processor 908 and an address value in the memory 902 based on a block size (e.g., a length of the codeword) of a received signal received through the channel and a parity-check matrix corresponding to a code rate.

The memory 902 stores input data and output data of the variable node processor 904 and the check node processor 908.

The variable node processor 904 receives data from the memory 902 according to address information and number information of input data received from the controller 906 and performs a variable node operation. The variable node processor 904 stores the variable node operation results in the memory 902 based on address information and number information of output data received from the controller 906. Further, the variable node processor 904 inputs the variable node operation results to the output processor 910 based on data received from the input processor 901 and the memory 902. The variable node operation has been described above based on FIG. 6.

The check node processor 908 receives data from the memory 902 and performs check node operations based on address information and number information of input data received from the controller 906. The check node processor 908 stores the check node operation results in the memory 902 based on address information and number information of output data received from the controller 906. Here, the check node operation has been described above based on FIG. 6.

The output processor 910 makes a hard decision on whether information bits of the codeword from the transmitting side were 0 or 1 based on data received from the variable node processor 904, and then outputs the hard decision result, and the output value of the output processor 910 becomes the final decoded value. In this case, the hard decision may be made based on the sum of all message values (the initial message value and all message values received from the check nodes) that are input to a single variable node, as illustrated in FIG. 6.

The memory 902 of the decoding device 900 may store information on a code rate, codeword length, and parity-check matrix of the LDPC code, and the LDPC decoding unit 810 may perform LDPC encoding using this information. However, this is merely one example, and the relevant information may also be provided by the transmitting side.

For reference, although the disclosure describes forward error correction (FEC) techniques in a communication system with a focus on LDPC codes, FEC encoding and decoding in the communication system may generally be subdivided into concatenated codes, such as outer codes and inner codes. According to the definitions of outer and inner codes, the transmitter performs inner encoding after outer encoding, and the receiver performs outer decoding after inner decoding.

In the case of outer codes, algebraic codes that allow relatively simple error detection or correction, such as cyclic redundancy check (CRC) codes, Bose-Chaudhuri-Hocquenghem (BCH) codes, and Reed-Solomon (RS) codes, are widely used, but the use of external codes is not necessarily limited to these, and multiple codes may also be applied in combination.

In the case of inner codes, relatively complex but excellent error correction coding schemes such as LDPC codes, Turbo codes, and Polar codes are widely used, but the use of inner codes is not necessarily limited to these. (e.g., tail-biting convolutional codes or other algebraic codes may be used, and multiple codes may also be applied in combination.) For reference, in the 3GPP 5G system, CRC codes are used as outer codes, LDPC codes are used as inner codes for data channels, and Polar codes are used as inner codes for control channels.

Various broadcasting and communication systems use LDPC codes optimized for each system, and in the disclosure, a system is basically described that uses LDPC codes defined based on a parity-check matrix having the same structure as that of LDPC codes used in the 3GPP 5G system, but the disclosure is not necessarily limited to such a system. Communication systems including 5G or 6G system may apply rate matching at the transmitter and rate dematching at the receiver in order to support various code rates and code lengths, however in systems that perform encoding and decoding based on fixed LDPC codes, such as some broadcasting systems, rate matching, rate dematching, and other operations may be entirely or partially omitted.

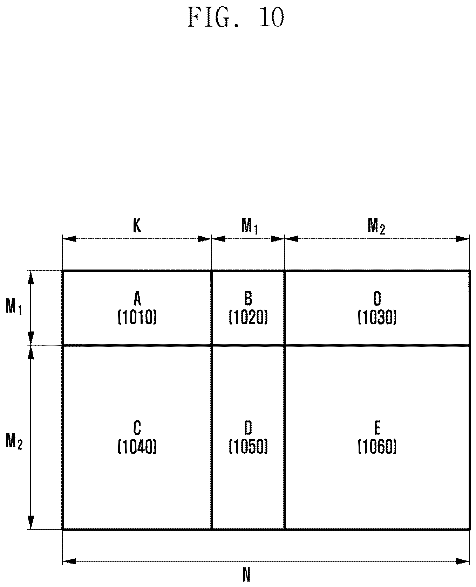

FIG. 10 is a diagram illustrating an example general structure of a parity-check matrix of an LDPC code, which is an inner code applied to an FEC encoding unit (not illustrated) and an FEC decoding unit (not illustrated) according to various embodiments.

The parity-check matrix illustrated in FIG. 10 has N columns, and $(M_1 + M_2)$ rows. (where $M_1, M_2 \geq 0$ and $M_1 + M_2 > 0$). In general, when a parity-check matrix has a full rank, the number of columns corresponding to information bits in the parity-check matrix is equal to the total number of columns minus the total number of rows. That is, if the parity-check matrix in FIG. 10 has a full rank $(M_1 + M_2)$, the number K of information bits is given by $K = N - (M_1 + M_2)$. In the disclosure, for convenience, only the case where the parity-check matrix of FIG. 10 has a full rank is described, but it is not necessarily limited thereto.

The parity-check matrix in FIG. 10 may be divided into a first part of the parity-check matrix including submatrices A 1010 and B 1020 and a second part of the parity-check matrix including submatrices C 1040, D 1050, and E 1060 (where if either $M_1$ or $M_2$ is 0, the parity-check matrix may not be divided into the first part and the second part). A submatrix O 1030 represents an $(M_1 \times M_2)$ zero matrix. Because the submatrix O 1030 is an $M_1 \times M_2$ zero matrix, even if it is included in the first part of the parity-check matrix, it does not affect matrix operations. For this reason, in the disclosure, the first part of the parity-check matrix is defined, for convenience, as a matrix including submatrices A 1010 and B 1020, excluding the $(M_1 \times M_2)$ zero matrix, but the first part of the parity-check matrix may also include the $(M_1 \times M_2)$ zero-matrix when necessary.

If the parity-check matrix in FIG. 10 is defined as a QC LDPC code with a lifting size or block size of Z, the parity-check matrix in FIG. 10 may correspond to a base matrix or weight matrix of size $m_b \times n_b$, where $k_b = K/Z$, $n_b = N/Z$, and $m_b = (M_1 + M_2)/Z$. Similarly, the first part of the parity-check matrix, including submatrices A 1010 and B 1020, corresponds to a submatrix of a base matrix or weight matrix of size $\left(\frac{M_1}{Z}\right) \times \left(\frac{K+M_1}{Z}\right)$ or $\left(\frac{M_1}{Z}\right) \times \left(k_b + \frac{M_1}{Z}\right)$, and the second part of the parity-check matrix, including submatrices C 1040, D 1050, and E 1060, corresponds to a submatrix of a base matrix or weight matrix of size $\left(\frac{M_2}{Z}\right) \times \left(\frac{K+M_1+M_2}{Z}\right)$ or $\left(\frac{M_2}{Z}\right) \times n_b$. (For convenience, it may also be represented as $m_{b1} = M_1/Z$, $m_{b2} = M_2/Z$).

When the parity-check matrix in FIG. 10 is denoted as H for convenience, information bits (or information bit vector) corresponding to the submatrix A 1010 or C 1040 are denoted as $\underline{i} = (i_0, i_1, i_2, \ldots, i_{K-1})$, first parity bits (or first parity bit vector) corresponding to the submatrix B 1020 or D 1050 are denoted as $\underline{w_1} = (w_{1,0}, w_{1,1}, w_{1,2}, \ldots, w_{1,M_1-1})$, and second parity bits (or second parity bit vector) corresponding to the submatrix E 1060 are denoted as $\underline{w_2} = (w_{2,0}, w_{2,1}, w_{2,2}, \ldots, w_{2,M_2-1})$, the relationship of Equation 13 may be derived from Equation 1.

[Equation 13]

$$H \cdot c^T = H \cdot \begin{bmatrix} \underline{i}^T \\ \underline{w}_1^T \\ \underline{w}_2^T \end{bmatrix} = \begin{bmatrix} A & B & O \\ C & D & E \end{bmatrix} \cdot \begin{bmatrix} \underline{i}^T \\ \underline{w}_1^T \\ \underline{w}_2^T \end{bmatrix}$$

$$= \begin{cases} A \cdot \underline{i}^T + B \cdot \underline{w}_1^T = 0 \\ C \cdot \underline{i}^T + D \cdot \underline{w}_1^T + E \cdot \underline{w}_2^T = 0 \end{cases}$$

With reference to Equation 13, the first parity vector $\underline{w}_1$ may be obtained (or calculated or determined) based on the information bit vector i and the first part of the parity-check matrix. Further, after the parity vector $\underline{w}_1$ is obtained, the parity vector $\underline{w}_2$ may be obtained (or calculated or determined) based on the information bit vector $\underline{i}$, the first parity vector $\underline{w}_1$, and the second part of the parity-check matrix.

In the disclosure, the first part of the parity-check matrix, including A 1010 and B 1020 necessary for generating the first parity vector $\underline{w}_1$ based on the information bit vector $\underline{i}$, may be conveniently referred to as a core part or matrix, kernel part or matrix, or precoding part or matrix. Further, the second part of the parity-check matrix, including C 1040, D 1050, and E 1060 necessary for generating a second parity vector $\underline{w}_2$ based on the information bit vector $\underline{i}$ and/or the first parity vector $\underline{w}_1$, may be referred to as an extension part or a single parity-check extension part.

As a specific example, core matrix portions of base matrix 1 $M(\mathbf{H}_{BG1})$ and base matrix 2 $M(\mathbf{H}_{BG2})$, defined in the 3GPP 5G standard described above, are represented as follows.

Core matrix of M($\mathbf{H}_{BG1}$):

```
0 1 2 3 5 6 9 10 11 12 13 15 16 18 19 20 21 22 23
0 2 3 4 5 7 8 9 11 12 14 15 16 17 19 21 22 23 24
0 1 2 4 5 6 7 8 9 10 13 14 15 17 18 19 20 24 25
0 1 3 4 6 7 8 10 11 12 13 14 16 17 18 20 21 22 25
```

Core matrix of M($\mathbf{H}_{BG2}$):

```
0 1 2 3 6 9 10 11
0 3 4 5 6 7 8 9 11 12
0 1 3 4 8 10 12 13
1 2 4 5 6 7 8 9 10 13
```

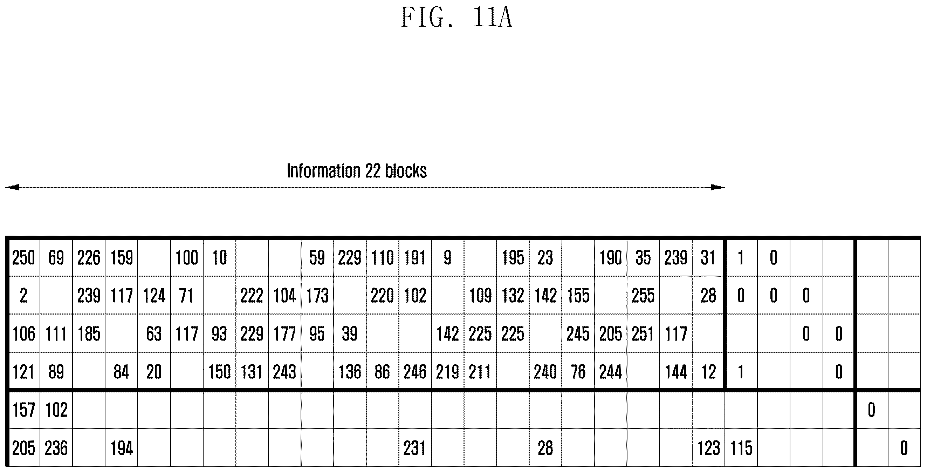

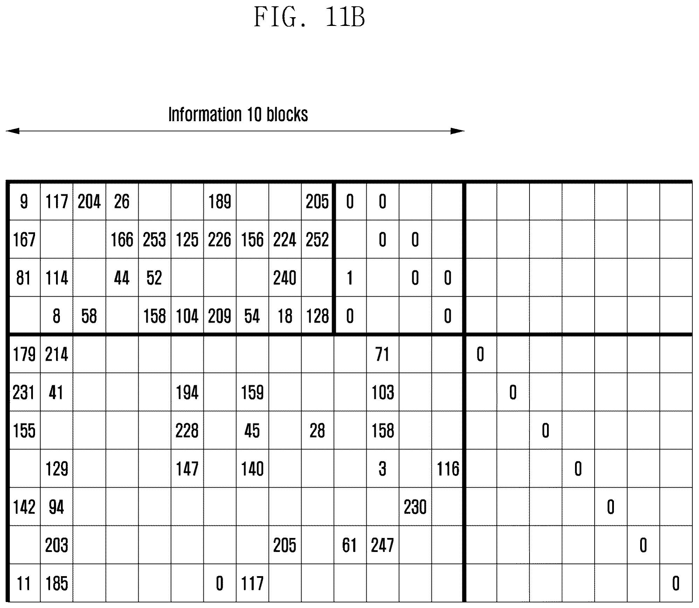

The size of the core matrix of $M(\mathbf{H}_{BG1})$ is $4\times26$, and the size of the core matrix of $M(\mathbf{H}_{BG2})$ is $4\times14$. Further, sizes of the core matrices based on the parity-check matrix are $4Z\times26Z$ and $4Z\times14Z$, respectively. As a specific example, parts of exponent matrices of LDPC codes defined for the case where the lifting size set index $i_{LS} = 0$ in the 3GPP 5G specification TS 38.212 are illustrated in FIGS. 11A and 11B. Portions corresponding to core matrices of the base matrices or the parity-check matrices in FIGS. 11A and 11B are as follows.

Core matrix of $V(\mathbf{H}_1)$, $i_{LS} = 0$:

```
250 69 226 159 100 10 59 229 110 191 9 195 23 190 35 239 31 1 0
2 239 117 124 71 222 104 173 220 102 109 132 142 155 255 28 0 0 0
106 111 185 63 117 93 229 177 95 39 142 225 225 245 205 251 117 0 0
121 89 84 20 150 131 243 136 86 246 219 211 240 76 244 144 12 1 0
```

Core matrix of $V(\mathbf{H}_2)$, $i_{LS} = 0$:

```
9 117 204 26 189 205 0 0
167 166 253 125 226 156 224 252 0 0
81 114 44 52 240 1 0 0
858 158 104 209 54 18 12800
```

In the disclosure, a parity-check matrix based on the following conditions may be considered for the parity-check matrix corresponding to FIG. 10.

The submatrix A 1010 and submatrix B 1020 may be referred to as a first submatrix and a second submatrix, respectively. Further, in the following description, a circulant permutation matrix may refer to a $Z \times Z$ circulant permutation matrix determined based on the lifting size Z, and may be as illustrated, for example, in Equation 5 or Equation 6. Further, in the disclosure, a circulant matrix may refer to a matrix in which circulant permutation matrices are overlapped.

<u>Condition 1(a):</u> In the parity-check matrix of the QC-LDPC code in FIG. 10, in the case where the submatrix B 1020 does not include any circulant matrix formed by overlapping $Z \times Z$ circulant permutation matrices, all column blocks in the submatrix B 1020 have a weight of 2 or more, and at least one column block having an odd weight of 3 or more may be included in the submatrix B 1020. Further, all columns of the base matrix $M(\mathbf{B})$ corresponding to the submatrix B 1020 have a weight of 2 or more, and at least one column having an odd weight of 3 or more may be included in the base matrix $M(\mathbf{B})$.

<u>Condition 1(b):</u> In the parity-check matrix of the QC-LDPC code in FIG. 10, in the case where the submatrix B 1020 includes at least one circulant matrix formed by overlapping $Z \times Z$ circulant permutation matrices, all column blocks in the submatrix B 1020 have a weight of 2 or more, and at least one column block having an odd weight of 3 or more is included in the submatrix B 1020. Further, in the weight matrix $W(\mathbf{B})$ corresponding to the submatrix B 1020, the sum of entries in each column is 2 or more, and at least one column having an odd sum of 3 or more is included in the weight matrix $W(\mathbf{B})$. (The weight of a column block including a circulant matrix formed by overlapping $Z \times Z$ circulant permutation matrices may be 2 or 3 or more.)

<u>Condition 2:</u> All column weights and row weights of the submatrix E 1060 in FIG. 10 are 1. Further, column and row weights of submatrices in the base matrix and the weight matrix corresponding to the submatrix E 1060 are all 1. Therefore, E 1060 and submatrices in the base matrix and weight matrix corresponding to E 1060, are identity matrices, or may be transformed into identity matrices by applying appropriate column or row permutations. (That is, E 1060 is an identity matrix or a matrix that has an algebraic property equivalent to an identity matrix.) If the parity-check matrix in FIG. 10 is defined as a quasi-cyclic parity-check matrix, the submatrix E may include multiple $Z \times Z$ identity matrices.

FIGS. 11A and 11B are diagrams illustrating examples of a parity-check matrix that satisfy Conditions 1(a), 1(b), and 2 according to various embodiments. As briefly described above, FIG. 11A illustrates an example of the case where K = 22*Z, $M_1$ = 4*Z, and $M_2$ = 2*Z in FIG. 10, and FIG. 11B illustrates an example of the case where K = 10*Z, $M_1$ = 4*Z, and $M_2$ = 7*Z in FIG. 10. It is noted that because a code rate of the LDPC code corresponding to the parity-check matrix of FIGS. 10, 11A, and 11B is K/N, a codeword with a lower code rate may be generated as $M_2$ decreases. In other words, according to the disclosure, LDPC encoding and decoding may be performed based on a parity-check matrix that may support a lower code rate by further expanding columns of degree 1 while including FIGS. 11A and 11B.

In the case where a lifting size set is used for LDPC encoding or decoding of a parity-check matrix of a quasi-cyclic LDPC code, the number of columns of one column block of the parity-check matrix is greater than or equal to the minimum lifting size. For example, if values in Table 6 are used as lifting sizes, the number of columns of one column block of the parity-check matrix may be at least 4. Therefore, in a communication system in which lifting sizes in Table 6 are practically applied to the parity-check matrix of an LDPC code having a structure such as that of FIG. 10, FIG. 11A, and FIG. 11B that satisfy Condition 1(a), Condition 1(b), and Condition 2, the number of columns with degree 3 in the submatrix B 1020 is at least 4.

For reference, in the parity-check matrix, base matrix, or weight matrix, the core matrix may also be defined in a form that satisfies Condition 1(a), Condition 1(b), and Condition 2 by adding one or two rows, as described below. However, in the disclosure, for convenience, a submatrix that satisfies only Condition 1(a) and Condition 1(b) is regarded as the core matrix (or kernel matrix or precoding matrix).

Core matrix of $M(\mathbf{H_{BG1}})$:

```
0 1 2 3 5 6 9 10 11 12 13 15 16 18 19 20 21 22 23
0 2 3 4 5 7 8 9 11 12 14 15 16 17 19 21 22 23 24
0 1 2 4 5 6 7 8 9 10 13 14 15 17 18 19 20 24 25
0 1 3 4 6 7 8 10 11 12 13 14 16 17 18 20 21 22 25
0 1 2 6
```

Core matrix of $M(\mathbf{H_{BG2}})$:

```
0 1 2 3 6 9 10 11
0 3 4 5 6 7 8 9 11 12
0 1 3 4 8 10 12 13
1 2 4 5 6 7 8 9 10 13
0 1 11 14
```

As an embodiment of the disclosure, a method of improving the performance of an LDPC code according to a weight matrix and a method of improving the decoding convergence speed are described.

The core matrix of base matrix 2 $M(\mathbf{H_{BG2}})$, as defined in the **[base matrix determination method],** includes four rows and may also be represented as a weight matrix, as in Equation 14. Because LDPC codes defined by base matrix 1 $M$ ($\mathbf{H_{BG1}}$), or base matrix 2 $M(\mathbf{H_{BG2}})$, are defined such that one circulant permutation matrix corresponds to each ZxZ block, the base matrix and the weight matrix are essentially identical.

[Equation 14]

$$W(\mathbf{H_{BG2}}) = \begin{bmatrix} 1 & 1 & 1 & 1 & 0 & 0 & 1 & 0 & 0 & 1 & 1 & 1 & 0 & 0 \\ 1 & 0 & 0 & 1 & 1 & 1 & 1 & 1 & 1 & 1 & 0 & 1 & 1 & 0 \\ 1 & 1 & 0 & 1 & 1 & 0 & 0 & 0 & 1 & 0 & 1 & 0 & 1 & 1 \\ 0 & 1 & 1 & 0 & 1 & 1 & 1 & 1 & 1 & 1 & 1 & 0 & 0 & 1 \end{bmatrix}$$

In this way, LDPC codes designed such that at most one circulant permutation matrix corresponds to each ZxZ block are well-suited for layered decoding on a row-block basis during decoding. Thus, the structure of LDPC codes is well-suited for decoding using parallel processors operating on Z-units.

Because such a layered decoding method typically performs parallel processing with a single row block as the basic unit, it may be determined that one iteration decoding is complete when decoding has been performed for all row blocks. This implies that, if sufficient parallel processing processors are available, the decoding throughput achieved through layered decoding is inversely proportional to the number of row blocks. However, in the case of supporting the same code length using a parity-check matrix with fewer row blocks, the lifting size Z value increases further; thus, the number of parallel processing processors required to decode a single row block simultaneously also increases.

For example, the weight matrix $W(\mathbf{H_{BG2}})$ includes 4 rows and 14 columns, and weights of each column are 3, 3, 2, 3, 3, 2, 3, 2, 3, 3, 3, 2, 2, and 2, and a weight matrix $W(\mathbf{H'_{BG2}})$, including 3 rows and 13 columns with a weight distribution similar to that of $W(\mathbf{H_{BG2}})$, and a weight matrix $W(\mathbf{H''_{BG2}})$, including 2 rows and 12 columns with a weight distribution similar to that of $W(\mathbf{H_{BG2}})$, may be constructed as follows.

$$W(\mathbf{H'_{BG2}}) = \begin{bmatrix} 1 & 1 & 1 & 1 & 1 & 1 & 1 & 0 & 1 & 1 & 1 & 1 & 0 \\ 1 & 1 & 0 & 1 & 1 & 1 & 1 & 1 & 1 & 1 & 1 & 1 & 1 \\ 1 & 1 & 1 & 1 & 1 & 0 & 1 & 1 & 1 & 1 & 1 & 0 & 1 \end{bmatrix},$$

$$W(\mathbf{H''_{BG2}}) = \begin{bmatrix} 2 & 1 & 1 & 2 & 1 & 1 & 2 & 1 & 1 & 2 & 1 & 1 \\ 1 & 2 & 1 & 1 & 2 & 1 & 1 & 1 & 2 & 1 & 2 & 1 \end{bmatrix}.$$

When LDPC codes with the same code length are generated using each of weight matrices $W(\mathbf{H_{BG2}})$, $W(\mathbf{H'_{BG2}})$, and $W(\mathbf{H''_{BG2}})$, and lifting sizes corresponding to the respective parity check matrices are $Z_1$, $Z_2$, and $Z_3$, there is a relationship such that $Z_3 = \frac{14}{12}Z_1$, $Z_2 = \frac{13}{12}Z_1$. If $Z_i$ parallel processing processors are available in the LDPC decoder, the approximate decoding throughput $W(\mathbf{H'_{BG2}})$ may be 1.5 times that of $W(\mathbf{H_{BG2}})$ and $W(\mathbf{H''_{BG2}})$ may be 2 times that of $W(\mathbf{H_{BG2}})$.

In this way, in the case where sufficient parallel processing processors are available, reducing the number of row blocks may increase the decoding throughput inversely. Therefore, for systems requiring extremely high decoding throughput, if more parallel processing processors are available, it is advantageous to keep the number of rows in the base matrix or the weight matrix, in other words, the number of row blocks in the parity-check matrix, small.

Although keeping the number of rows of the base matrix or the weight matrix, in other words, the number of row blocks of the parity-check matrix, small may be advantageous from the viewpoint of decoding throughput, in the case where the number of row blocks is configured too small, it may impose serious constraints on algebraic properties such as cycle characteristics or minimum distance characteristics of the LDPC code, resulting in performance degradation. Therefore, the base matrix or the weight matrix should be determined by simultaneously considering the target throughput and target error correction capability of the system.

As an embodiment of the disclosure, a method of improving the performance of a code while having a high decoding information throughput is disclosed. For example, the disclosure provides algebraic properties that a core matrix portion of a base matrix or a weight matrix, which is closely related to the maximum decoding throughput or the peak data rate of a system, should satisfy. In the case where the parity-check matrix does not include a second part of the parity-check matrix including submatrices C 1040, D 1050, and E 1060 of FIG. 10, the core matrix may be identical to the base matrix or the weight matrix.

One of conditions that the core matrix of the parity-check matrix should satisfy is that, when two columns having only one non-zero entry are selected from the weight matrix corresponding to the core matrix, non-zero entries should not be included to a single row, as in $\begin{bmatrix} 0 & 0 \\ \vdots & \vdots \\ w_1 & w_2 \\ \vdots & \vdots \\ 0 & 0 \end{bmatrix}$ ($w_1$, $w_2 \geq 1$). Simple examples include

$\begin{bmatrix} w_1 & w_2 \\ 0 & 0 \end{bmatrix}$ ,, $\begin{bmatrix} 0 & 0 \\ w_1 & w_2 \end{bmatrix}$ , $\begin{bmatrix} w_1 & w_2 \\ 0 & 0 \\ 0 & 0 \end{bmatrix}$ , $\begin{bmatrix} 0 & 0 \\ w_1 & w_2 \\ 0 & 0 \end{bmatrix}$ , .... Because the minimum distance of the parity-check matrix corresponding to the weight matrix or its core matrix including such a structure is $w_1 + w_2$ or less, there is a high possibility that the error floor phenomenon may easily occur. Therefore, as in

$\begin{bmatrix} w_1 & 0 \\ 0 & w_2 \end{bmatrix}$ , $\begin{bmatrix} w_1 & 0 \\ 0 & w_2 \\ 0 & 0 \end{bmatrix}$ , $\begin{bmatrix} w_1 & 0 \\ 0 & 0 \\ 0 & w_2 \end{bmatrix}$ , ..., in any two columns in which there is only one non-zero entry, non-zero entries should be located in different rows. Thus, even for the base matrix, all non-zero entries located in columns with weight 1 are located in different rows. The above description may be defined as Conditions 3(a) and 3(b) below.

<u>Condition 3(a):</u> All columns of the base matrix or weight matrix corresponding to the core matrix have a weight of 2 or more, or the number of columns having a weight of 1 is at most 1.

<u>Condition 3(b):</u> In the case where there are two or more columns having a weight of 1 among columns of the base matrix or weight matrix corresponding to the core matrix, non-zero entries included in columns having a weight of 1 are located in different rows.

Conditions 3(a) and 3(b) may refer, for example, to the case where the number of column blocks including only a single circulant permutation matrix or a circulant matrix included in the core matrix is at most 1, or in the case where the core matrix includes two or more column blocks including a single circulant permutation matrix or circulant matrix, the ZxZ circulant permutation matrices or circulant matrices should be included in different row blocks. Conditions 3(a) and 3(b) are structures for preventing/reducing a serious error floor phenomenon, but the following Condition 4 may be further added in order to obtain a better error floor characteristic. As described above, the circulant permutation matrix and the circulant matrix may have a size of ZxZ.

<u>Condition 4:</u> In the parity-check matrix corresponding to the core matrix, a column corresponding to the information bit (or input bit or code block) has a weight of 3 or more.

In Condition 4, as in the parity-check matrix corresponding to the base matrix 2M($\mathbf{H_{BG2}}$) of Equation 14, the encoding gain may be reduced by ensuring that no column corresponding to an information bit has a weight of 2, but it may be applied to improve the error floor phenomenon.

Condition 4 specifies that in the parity-check matrix for the QC-LDPC code, in the case where the submatrix A 1010 does not include a circulant matrix formed by overlapping ZxZ circulant permutation matrices, all column blocks of the submatrix A 1010 have a weight of 3 or more, and all columns of the base matrix M($\mathbf{A}$) corresponding to the submatrix A 1010 also have a weight of 3 or more. Further, in the parity-check matrix for the QC-LDPC code, in the case where the submatrix A 1010 includes at least one circulant matrix formed by overlapping ZxZ circulant permutation matrices, all column blocks of the submatrix A 1010 have a weight of 3 or more, and the sum of entries of all columns of the weight matrix W($\mathbf{A}$) corresponding to the submatrix A 1010 is 3 or more.

As another condition that the core matrix of the parity-check matrix should satisfy, it may be considered that the weight matrix corresponding to the core matrix includes no entry of 3 or more. In general, in the case where the core matrix of the weight matrix includes an entry, which is an integer of 3 or more, three or more circulant permutation matrices correspond to the corresponding position, and in the case where three or more circulant permutation matrices of a ZxZ circulant matrix overlap, the maximum cycle length is limited to 6 regardless of the value of Z. In the case where the cycle length is short, because the performance improvement effect by iterative decoding is reduced, a parity-check matrix corresponding to a weight matrix or core matrix containing entries of 3 or more is suitable for use in the case where the code length is short or where the code rate is relatively high. Because the disclosure deals with a design method of an LDPC code supporting various code rates and lengths, the core matrix of the weight matrix is designed so that it includes no entries of 3 or more (entries may be included in the portion corresponding to the single parity check extension). The above description may be defined as Condition 5.

**Condition 5:** The weight matrix corresponding to the core matrix includes only 0 and 1, or only 0, 1, and 2.

As another condition that the core matrix should satisfy, the submatrix B 1020 of FIG. 10 corresponding to the first parity vector $\underline{w_1}$ should have the maximum rank in order to enable efficient encoding, and the following restrictive structure is desirable to prevent/reduce serious degradation in cycle characteristics.

**Condition 6(a):** In the case where the weight matrix corresponding to the core matrix includes four rows, a submatrix corresponding to B 1020 in the weight matrix and the base matrix is one of the following:

$$\begin{bmatrix} 1 & 1 & 0 & 0 \\ 1 & 1 & 1 & 0 \\ 0 & 0 & 1 & 1 \\ 1 & 0 & 0 & 1 \end{bmatrix}, \begin{bmatrix} 1 & 1 & 0 & 0 \\ 0 & 1 & 1 & 0 \\ 1 & 0 & 1 & 1 \\ 1 & 0 & 0 & 1 \end{bmatrix}, \begin{bmatrix} 1 & 1 & 0 & 0 \\ 1 & 1 & 1 & 0 \\ 0 & 0 & 1 & 1 \\ 1 & 0 & 1 & 1 \end{bmatrix}, \begin{bmatrix} 1 & 1 & 0 & 0 \\ 0 & 1 & 1 & 0 \\ 1 & 1 & 1 & 1 \\ 1 & 0 & 1 & 1 \end{bmatrix},$$

$$\begin{bmatrix} 1 & 1 & 0 & 0 \\ 0 & 1 & 1 & 0 \\ 1 & 1 & 1 & 1 \\ 1 & 0 & 1 & 1 \end{bmatrix}, \begin{bmatrix} 1 & 1 & 0 & 0 \\ 0 & 1 & 1 & 0 \\ 1 & 0 & 1 & 1 \\ 1 & 1 & 1 & 1 \end{bmatrix}$$

**Condition 6(b):** In the case where the weight matrix corresponding to the core matrix includes three rows, a submatrix of the base matrix corresponding to the submatrix B 1020 is $\begin{bmatrix} 1 & 1 & 0 \\ 1 & 1 & 1 \\ 1 & 0 & 1 \end{bmatrix}$, and the weight matrix is one of the following:

$$\begin{bmatrix} 1 & 1 & 0 \\ 1 & 1 & 1 \\ 1 & 0 & 1 \end{bmatrix}, \begin{bmatrix} 1 & 1 & 0 \\ 0 & 1 & 1 \\ 2 & 0 & 1 \end{bmatrix}, \begin{bmatrix} 2 & 1 & 0 \\ 0 & 1 & 1 \\ 1 & 0 & 1 \end{bmatrix}, \begin{bmatrix} 1 & 2 & 0 \\ 0 & 1 & 1 \\ 2 & 0 & 1 \end{bmatrix}, \begin{bmatrix} 1 & 2 & 0 \\ 0 & 1 & 2 \\ 2 & 0 & 1 \end{bmatrix}.$$

**Condition 6(c):** In the case where the weight matrix corresponding to the core matrix includes two rows, a submatrix of the base matrix corresponding to the submatrix B 1020 is $\begin{bmatrix} 1 & 1 \\ 1 & 1 \end{bmatrix}$, and the weight matrix is one of the following: $\begin{bmatrix} 1 & 1 \\ 2 & 1 \end{bmatrix}, \begin{bmatrix} 1 & 2 \\ 2 & 1 \end{bmatrix}.$

For reference, Condition 6(a) illustrates the case where the weight matrix and the base matrix are the same, and Condition 6(b) illustrates that the weight matrix has the same form as that of the base matrix only in the case where the weight matrix is $\begin{bmatrix} 1 & 1 & 0 \\ 1 & 1 & 1 \\ 1 & 0 & 1 \end{bmatrix}$. In the base matrix or weight matrix illustrated in Conditions 6(a), 6(b), and 6(c), 0 may refer, for example, to a ZxZ zero matrix, and 1 may refer, for example, to a ZxZ identity matrix $I = (P^0)$ or a circulant permutation matrix $P^v (v > 0)$. 2 may refer, for example, to a ZxZ circulant matrix $(P^{v_1} + P^{v_2})$. $(v_1, v_2 \geq 0, v_1 \neq v_2)$

In general, an upper bound on the cycle length may be predicted from the base matrix or weight matrix, but cycle characteristics of the parity-check matrix corresponding to the base matrix or weight matrix are unknown. For example, if the submatrix B 1020 is $\begin{bmatrix} I & I \\ P^{v_1} + P^{v_2} & I \end{bmatrix}$ or $\begin{bmatrix} I & I & 0 \\ P^{v_1} & I & I \\ P^{v_2} & 0 & I \end{bmatrix}$, then in each case, regardless of a value of v1 and v2, the base matrix or weight matrix is the same as $\begin{bmatrix} 1 & 1 \\ 2 & 1 \end{bmatrix}$ or $\begin{bmatrix} 1 & 1 & 0 \\ 1 & 1 & 1 \\ 1 & 0 & 1 \end{bmatrix}$, but there is a big difference in cycle characteristics. In the case of $\begin{bmatrix} I & I \\ P^{v_1} + P^{v_2} & I \end{bmatrix}$, when at least one of v1 or v2 $v_1 \equiv v_2 \left( \mathrm{mod} \frac{Z}{2} \right)$ v1 (or

$v_1 - v_2 \equiv \frac{Z}{2} (\mathrm{mod}\, Z)$ ), a large number of 4-cycles are generated; thus, v1 and v2 are basically configured to an integer satisfying $v_1, v_2 (\mathrm{mod}\, Z) > 0, v_1 \not\equiv v_2 \left( \mathrm{mod} \frac{Z}{2} \right)$ (or $v_1 - v_2 \not\equiv \frac{Z}{2} (\mathrm{mod}\, Z)$ ). Similarly, in the

case of $\begin{bmatrix} I & I & 0 \\ P^{v_1} & I & I \\ P^{v_2} & 0 & I \end{bmatrix}$, if v1 = 0, a large number of 4-cycles are generated; thus, v1 is basically configured to an integer

satisfying $v_1 (\mathrm{mod}\, Z) \geq 1$, and v2 is basically configured to an integer satisfying $v_2 (\mathrm{mod}\, Z) \geq 0$. The above description is only a method of removing 4-cycles, and in order to obtain longer cycles, values of v1 and v2 may be restricted in various ways.

In the case where the communication system applies puncturing of the information bits described in [Table 9], the following conditions that the core matrix should satisfy may be added.

<u>Condition 7</u>: In an LDPC encoding system to which puncturing of information bits is applied, a submatrix of a core matrix including only columns corresponding to the punctured information bits has at least one row with a row weight of 1.

Because bits punctured at the receiver are regarded as bits lost during the reception process, the probability that the punctured bits are 0 and 1 is determined to be the same. This usually refers to 1 when decoding is performed using the LR value, and 0 when decoding is performed using the LLR value, but it may be determined in another form based on values used in the decoding process. In the case where LDPC decoding is performed based on a parity-check matrix that does not satisfy Condition 7, the punctured information bits may not be decoded in the case where maximum likelihood (ML) decoding or pseudo ML decoding scheme is not used. Because an ML or pseudo ML decoding scheme is not commonly used due to its complexity, the parity-check matrix may be determined to satisfy Condition 7 in order to ensure decoding success.

In the case where the LDPC code is a QC-LDPC code, the parity-check matrix may be expressed based on the lifting size Z value, the base matrix, and/or weight matrix and/or exponent matrix; thus, it may be expressed as in the following Condition 8.

<u>Condition 8:</u> In a QC-LDPC encoding system in which puncturing of information bits is applied in units of the lifting size Z or a multiple thereof, a submatrix of the base matrix including only a columns corresponding to a submatrix of the core matrix including only a*Z columns (a: integer greater than or equal to 1) corresponding to the punctured a*Z information bits includes at least one row of a weight 1. Further, a submatrix of the weight matrix including a columns corresponding to a submatrix of the core matrix including only a*Z columns includes at least one row of a weight 1 and an entry of 1.

For example, in a QC-LDPC encoding system where 2Z information bits are always punctured, Condition 8 indicates that a = 2.

In the disclosure, at least one of the above conditions may be used for a parity-check matrix. That is, the parity-check matrix may be determined to satisfy one of the above conditions, or to satisfy a combination of at least two of the above conditions.

Electronic devices according to various embodiments disclosed in this disclosure may be devices of various forms. The electronic devices may include, for example, at least one of a portable communication device (e.g., smartphone), a TV, a computer device, a portable multimedia device, a portable medical device, a camera, a wearable device, a home appliance, or the like. Electronic devices according to embodiments of this disclosure are not limited to the above-described devices. Further, the operation of transmitting a frame may refer not only to transmission through a wireless channel or the like, but also to the inclusion of an interface for outputting a frame for transmission in various electronic devices. For example, a processor may output a frame to an RF front end for transmission via a bus interface. Similarly, the operation of receiving a frame from another device may refer to the presence of an interface in various electronic devices for obtaining a frame received from another device. For example, a processor may receive or obtain a frame from an RF front end via a bus interface.

Various embodiments of the disclosure and terms used therein are not intended to limit the technology described in this disclosure to a specific embodiment, but it should be understood to include various modifications, equivalents, and/or substitutions of various embodiments.

In connection with the description of the drawings, similar reference numerals may be used for similar components. The singular expression may include the plural expression unless the context clearly dictates otherwise. In the disclosure, expressions such as "A or B", "at least one of A and/or B", "A, B or C" or "at least one of A, B and/or C" may include all possible combinations of items listed together. Expressions such as "first" or "second", and the like may be used to refer to components without implying any order or importance, and are merely used to distinguish one component from another component and should not be construed as limiting. When any (e.g., first) component is referred to as being "connected (functionally or communicatively)" or "accessed" to another (e.g., second) component, the component may be directly connected to the component or may be connected through another component (e.g., third component).

The term "determining" may encompass various meanings depending on the situation, such as identifying, calculating or computing, processing, deriving, investigating, estimating, looking up (e.g., from a database or other data structure), ascertaining, and the like.

The order of description in the drawings illustrating the method of the disclosure does not necessarily correspond to the order of execution, and the order of precedence may be altered or performed in parallel.

The drawings illustrating example methods of the disclosure may omit some components and include only some components within a scope that does not harm the essence of the disclosure.

Example methods of the disclosure may be implemented by combining some or all of the contents included in each embodiment within a scope that does not harm the essence of the disclosure.

The disclosure has been described with reference to various example embodiments, but various modifications and variations may be suggested to those skilled in the art. Such modifications and variations are intended to be encompassed by the appended claims. Further, it is evident that, for convenience of description, operations represented by different blocks in the flowchart of the disclosure may be implemented separately by multiple processors in an actual system, or may be integrated into a single processor. It will also be understood that any of the embodiment(s) described herein may be used in conjunction with any other embodiment(s) described herein.

**Claims**

1. A method performed by a transmitter in a communication system, the method comprising:

   determining a number of input bits;
   determining a base matrix based on the number of input bits;
   determining a lifting size based on at least one of the number of input bits or the base matrix;
   determining a parity-check matrix based on at least one of the base matrix or the lifting size; and
   performing encoding based on the parity-check matrix and the input bits,
   wherein the parity-check matrix comprises a core matrix including a first submatrix corresponding to the input bits and a second submatrix corresponding to first parity bits, the second submatrix having a column-block weight greater than or equal to 2,
   wherein a number of column blocks include a single ZxZ circulant permutation matrix or a circulant matrix included in the core matrix is at most 1, or
   wherein, in case that the number of column blocks including a single ZxZ circulant permutation matrix or a circulant matrix included in the core matrix is greater than or equal to 2, the ZxZ circulant permutation matrices or circulant matrices included in the column blocks are included in different row blocks.

2. The method of claim 1, wherein the column-block weight included in the first submatrix is greater than or equal to 3.

3. The method of claim 1, wherein at least one circulant matrix, in which two $Z \times Z$ circulant permutation matrices overlap, is included in a column block of the second submatrix having a weight of 3.

4. The method of claim 3, wherein the second submatrix comprises $\begin{bmatrix} I & I \\ P^{v_1} + P^{v_2} & I \end{bmatrix}$ , ( $v_1, v_2 (\mathrm{mod}\, Z) > 0,\ v_1 \not\equiv v_2 \left(\mathrm{mod}\frac{Z}{2}\right)$ ).

5. A method performed by a receiver in a communication system, the method comprising:

   receiving a signal;

determining a number of input bits based on the signal;
determining a base matrix based on the number of input bits;
determining a lifting size based on at least one of the number of input bits or the base matrix;
determining a parity-check matrix based on at least one of the base matrix or the lifting size; and
performing decoding of the signal based on the parity-check matrix,
wherein the parity-check matrix comprises a core matrix including a first submatrix corresponding to the input bits and a second submatrix corresponding to first parity bits, the second submatrix having a column-block weight greater than or equal to 2,
wherein a number of column blocks including a single ZxZ circulant permutation matrix or a circulant matrix included in the core matrix is at most 1, or
wherein, in case that the number of column blocks including a single ZxZ circulant permutation matrix or a circulant matrix included in the core matrix is greater than or equal to 2, the ZxZ circulant permutation matrices or circulant matrices included in the column blocks are included in different row blocks.

6. The method of claim 5, wherein the column-block weight included in the first submatrix is greater than or equal to 3.

7. The method of claim 5, wherein at least one circulant matrix, in which two $Z \times Z$ circulant permutation matrices overlap, is included in a column block of the second submatrix having a weight of 3.

8. The method of claim 7, wherein the second submatrix comprises $\begin{bmatrix} I & I \\ P^{v_1} + P^{v_2} & I \end{bmatrix}$ , ( $v_1, v_2 (\mathrm{mod}\ Z) > 0,\ v_1 \not\equiv v_2 \left(\mathrm{mod}\dfrac{Z}{2}\right)$ ).

9. A transmitter in a communication system, the transmitter comprising:

a transceiver; and
a controller coupled with the transceiver and configured to:

determine a number of input bits,
determine a base matrix based on the number of input bits,
determine a lifting size based on at least one of the number of input bits or the base matrix,
determine a parity-check matrix based on at least one of the base matrix or the lifting size Z, and
perform encoding based on the parity-check matrix and the input bits,
wherein the parity-check matrix comprises a core matrix including a first submatrix corresponding to the input bits and a second submatrix corresponding to first parity bits, the second submatrix having a column-block weight greater than or equal to 2,
wherein a number of column blocks including a single Z x Z circulant permutation matrix or a circulant matrix included in the core matrix is at most 1, or
wherein, in case that the number of column blocks including a single ZxZ circulant permutation matrix or a circulant matrix included in the core matrix is greater than or equal to 2, the ZxZ circulant permutation matrices or circulant matrices included in the column blocks are included in different row blocks.

10. The transmitter of claim 9, wherein the column-block weight included in the first submatrix is greater than or equal to 3.

11. The transmitter of claim 9, wherein at least one circulant matrix, in which two $Z \times Z$ circulant permutation matrices overlap, is included in a column block of the second submatrix having a weight of 3.

12. The transmitter of claim 11, wherein the second submatrix comprises $\begin{bmatrix} I & I \\ P^{v_1} + P^{v_2} & I \end{bmatrix}$ , ($v_1, v_2 (\mathrm{mod}\ Z) > 0,\ v_1 \not\equiv v_2 \left(\mathrm{mod}\dfrac{Z}{2}\right)$ ).

13. A receiver in a communication system, the receiver comprising:

a transceiver; and
a controller coupled with the transceiver and configured to:

receive a signal,
determine a number of input bits based on the signal,
determine a base matrix based on the number of input bits,
determine a lifting size based on at least one of the number of the input bits or the base matrix,
determine a parity-check matrix based on at least one of the base matrix or the lifting size, and
perform decoding of the signal based on the parity-check matrix,
wherein the parity-check matrix comprises a core matrix including a first submatrix corresponding to the input bits and a second submatrix corresponding to first parity bits, the second submatrix having a column-block weight greater than or equal to 2,
wherein a number of column blocks including a single ZxZ circulant permutation matrix or a circulant matrix included in the core matrix is at most 1, or
wherein, in case that the number of column blocks including a single ZxZ circulant permutation matrix or a circulant matrix included in the core matrix is greater than or equal to 2, the ZxZ circulant permutation matrices or circulant matrices included in the column blocks are included in different row blocks.

14. The receiver of claim 13, wherein the column-block weight included in the first submatrix is greater than or equal to 3.

15. The receiver of claim 13, wherein at least one circulant matrix, in which two $Z \times Z$ circulant permutation matrices overlap, is included in a column block in the second submatrix having a weight of 3, and

the second submatrix comprises $\begin{bmatrix} I & I \\ P^{v_1} + P^{v_2} & I \end{bmatrix}$, ($v_1$, $v_2$ (mod $Z$) > 0, $v_1 \not\equiv v_2 \left( \mathrm{mod} \dfrac{Z}{2} \right)$).

FIG. 1

FIG. 2

$$H_1 = \begin{Bmatrix} 1 & 1 & 1 & 1 & 1 & 1 & 0 & 0 \\ 1 & 1 & 0 & 1 & 0 & 1 & 1 & 0 \\ 1 & 1 & 1 & 0 & 0 & 0 & 1 & 1 \\ 1 & 0 & 1 & 1 & 1 & 0 & 0 & 1 \end{Bmatrix}$$

FIG. 3A

FIG. 3B

EP 4 730 660 A1

# FIG. 4

Transport Block | TB-CRC

Code Block #0 | CB-CRC | FB — K

Code Block #1 | CB-CRC | FB — K

Code Block #2 | CB-CRC | FB — K

FB : filler bits

# FIG. 5

```
        ┌─────────────┐
        │    Start     │
        └──────┬──────┘
               │
               ▼
      ┌─────────────────┐  510
      │  Determine TBS   │
      └────────┬────────┘
               │
               ▼
          ╱─────────╲  520
         ╱           ╲        Yes
        ⟨  TBS > max CBS ? ⟩ ──────────┐
         ╲           ╱                  │
          ╲─────────╱                   ▼
               │ No             ┌──────────────────┐  530
               │                │   Segmentation    │
               ▼                └────────┬─────────┘
      ┌─────────────────────┐  540       │
      │ Determine block size Z │◄─────────┘
      └──────────┬──────────┘
                 │
                 ▼
      ┌──────────────────────────┐  550
      │ Determine LDPC exponent matrix │
      └─────────────┬────────────┘
                    │
                    ▼
      ┌─────────────────┐  560
      │  LDPC encoding   │
      └────────┬────────┘
               │
               ▼
        ┌─────────────┐
        │     End      │
        └─────────────┘
```

# FIG. 6

```
        ┌──────────────┐
        │    Start      │
        └──────┬───────┘
               │
               ▼
        ┌──────────────┐  610
        │ Determine TBS │
        └──────┬───────┘
               │
               ▼
          ◇ TBS > max CBS ? ◇ ──Yes──┐  620
               │                      ▼
              No              ┌──────────────────────┐  630
               │              │ Determine segmented   │
               ▼              │ CBS size              │
        ┌──────────────┐  640 └──────────┬───────────┘
        │ Determine     │◄───────────────┘
        │ block size Z  │
        └──────┬───────┘
               │
               ▼
        ┌──────────────────────┐  650
        │ Determine LDPC        │
        │ exponent matrix       │
        └──────┬───────────────┘
               │
               ▼
        ┌──────────────┐  660
        │ LDPC decoding │
        └──────┬───────┘
               │
               ▼
        ┌──────────────┐
        │     End       │
        └──────────────┘
```

# FIG. 7

Transmitting device (700)

| 710 | 720 | 730 | 740 | 750 |
|-----|-----|-----|-----|-----|
| Segmentation unit | Zero padding unit | LDPC encoding unit | Rate matching unit | Modulation unit |

741 — Interleaver

742 — Puncturing/repetition /zero removal unit

Rate matching unit (740)

EP 4 730 660 A1

FIG. 8

Receiving device (800)

| 810 | 820 | 830 | 840 | 850 |
|---|---|---|---|---|
| Demodulation unit | Rate dematching unit | LDPC decoding unit | Zero removal unit | Desegmentation unit |

Rate dematching unit (820)

| 822 | 823 | 824 |
|---|---|---|
| LLR insertion unit | LLR combiner | Deinterleaver |

EP 4 730 660 A1

# FIG. 9

900

901 Input processor

904 Variable node processor

910 Output processor

902 Memory

906 Controller

908 Check node processor

FIG. 10

FIG. 11A

Information 22 blocks

| 250 | 69 | 226 | 159 | | 100 | 10 | | | 59 | 229 | 110 | 191 | 9 | | 195 | 23 | | 190 | 35 | 239 | 31 | 1 | 0 | | | |
|---|---|---|---|---|---|---|---|---|---|---|---|---|---|---|---|---|---|---|---|---|---|---|---|---|---|---|
| 2 | | 239 | 117 | 124 | 71 | | 222 | 104 | 173 | | 220 | 102 | | 109 | 132 | 142 | 155 | | 255 | | 28 | 0 | 0 | 0 | | |
| 106 | 111 | 185 | | 63 | 117 | 93 | 229 | 177 | 95 | 39 | | | 142 | 225 | 225 | | 245 | 205 | 251 | 117 | | | | 0 | 0 | |
| 121 | 89 | | 84 | 20 | | 150 | 131 | 243 | | 136 | 86 | 246 | 219 | 211 | | 240 | 76 | 244 | | 144 | 12 | 1 | | | 0 | |
| 157 | 102 | | | | | | | | | | | | | | | | | | | | | | | | | 0 |
| 205 | 236 | | 194 | | | | | | | | 231 | | | 28 | | | | | | 123 | 115 | | | | | 0 |

EP 4 730 660 A1

FIG. 11B

Information 10 blocks ⟷

| 9 | 117 | 204 | 26 | | 189 | | | 205 | 0 | 0 | | | |
|---|---|---|---|---|---|---|---|---|---|---|---|---|---|
| 167 | | 166 | 253 | 125 | 226 | 156 | 224 | 252 | | 0 | 0 | | |
| 81 | 114 | | 44 | 52 | | | | 240 | 1 | | 0 | 0 | |
| | 8 | 58 | | 158 | 104 | 209 | 54 | 18 | 128 | 0 | | | 0 |
| 179 | 214 | | | | | | | | 71 | | 0 | | |
| 231 | 41 | | | 194 | | 159 | | | 103 | | | 0 | |
| 155 | | | | 228 | | 45 | | 28 | 158 | | | | 0 |
| | 129 | | | 147 | | 140 | | | 3 | | 116 | | 0 |
| 142 | 94 | | | | | | | | | 230 | | | 0 |
| | 203 | | | | | 205 | | 61 | 247 | | | | 0 |
| 11 | 185 | | | | 0 | 117 | | | | | | | 0 |

## INTERNATIONAL SEARCH REPORT

| International application No. |
|---|
| **PCT/KR2024/009954** |

| | |
|---|---|
| **A. CLASSIFICATION OF SUBJECT MATTER** | |
| **H03M 13/11**(2006.01)i; **H03M 13/00**(2006.01)i | |

According to International Patent Classification (IPC) or to both national classification and IPC

| **B. FIELDS SEARCHED** |
|---|

Minimum documentation searched (classification system followed by classification symbols)

H03M 13/11(2006.01); H03M 13/00(2006.01); H04L 1/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: LDPC(low density parity check), 행렬(matrix), 리프팅(lifting), 순환(circulant), 순열(permutation), 코어(core), 무게(weight)

| **C. DOCUMENTS CONSIDERED TO BE RELEVANT** |
|---|

| Category* | Citation of document, with indication, where appropriate, of the relevant passages | Relevant to claim No. |
|---|---|---|
| A | KR 10-2020-0132720 A (SAMSUNG ELECTRONICS CO., LTD.) 25 November 2020 (2020-11-25)<br>See paragraphs [0065], [0082]-[0083], [0111] and [0294]; and figures 4 and 18. | 1-15 |
| A | KR 10-2450243 B1 (LG ELECTRONICS INC.) 04 October 2022 (2022-10-04)<br>See paragraph [0097]; claim 1; and figure 8. | 1-15 |
| A | KR 10-2348466 B1 (SAMSUNG ELECTRONICS CO., LTD.) 10 January 2022 (2022-01-10)<br>See paragraphs [0102]-[0107]; and claims 1-4. | 1-15 |
| A | KR 10-2347823 B1 (ZTE CORPORATION) 05 January 2022 (2022-01-05)<br>See claims 1-8. | 1-15 |
| A | KR 10-1862812 B1 (BEIJING NUFRONT MOBILE MULTIMEDIA TECHNOLOGY CO., LTD.) 30 May 2018 (2018-05-30)<br>See claims 1 and 3-16. | 1-15 |

☐ Further documents are listed in the continuation of Box C.          ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" document member of the same patent family |
| "P" | document published prior to the international filing date but later than the priority date claimed | |

| Date of the actual completion of the international search | Date of mailing of the international search report |
|---|---|
| **16 October 2024** | **16 October 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/009954**

| Patent document cited in search report | | | Publication date (day/month/year) | Patent family member(s) | | | Publication date (day/month/year) |
|---|---|---|---|---|---|---|---|
| KR | 10-2020-0132720 | A | 25 November 2020 | CN | 113826327 | A | 21 December 2021 |
| | | | | EP | 3954049 | A1 | 16 February 2022 |
| | | | | EP | 3954049 | B1 | 17 April 2024 |
| | | | | EP | 4351007 | A2 | 10 April 2024 |
| | | | | US | 11075649 | B2 | 27 July 2021 |
| | | | | US | 11451243 | B2 | 20 September 2022 |
| | | | | US | 2020-0366317 | A1 | 19 November 2020 |
| | | | | US | 2021-0351792 | A1 | 11 November 2021 |
| | | | | WO | 2020-231235 | A1 | 19 November 2020 |
| KR | 10-2450243 | B1 | 04 October 2022 | CN | 115996061 | A | 21 April 2023 |
| | | | | EP | 3471276 | A1 | 17 April 2019 |
| | | | | JP | 2019-532585 | A | 07 November 2019 |
| | | | | JP | 6936854 | B2 | 22 September 2021 |
| | | | | KR | 10-2007855 | B1 | 06 August 2019 |
| | | | | KR | 10-2019-0107039 | A | 18 September 2019 |
| | | | | US | 11777525 | B2 | 03 October 2023 |
| | | | | US | 2021-0297091 | A1 | 23 September 2021 |
| | | | | WO | 2018-143743 | A1 | 09 August 2018 |
| KR | 10-2348466 | B1 | 10 January 2022 | CN | 110463045 | A | 15 November 2019 |
| | | | | CN | 110463045 | B | 01 December 2023 |
| | | | | EP | 3902143 | A1 | 27 October 2021 |
| | | | | EP | 3902143 | B1 | 07 August 2024 |
| | | | | KR | 10-2018-0111422 | A | 11 October 2018 |
| KR | 10-2347823 | B1 | 05 January 2022 | CN | 116827357 | A | 29 September 2023 |
| | | | | EP | 4231532 | A2 | 23 August 2023 |
| | | | | EP | 4231532 | A3 | 30 August 2023 |
| | | | | JP | 2022-058949 | A | 12 April 2022 |
| | | | | JP | 7372369 | B2 | 31 October 2023 |
| | | | | KR | 10-2021-0032007 | A | 23 March 2021 |
| | | | | KR | 10-2229233 | B1 | 22 March 2021 |
| | | | | US | 11323134 | B2 | 03 May 2022 |
| | | | | US | 2021-0091790 | A1 | 25 March 2021 |
| KR | 10-1862812 | B1 | 30 May 2018 | CN | 104106230 | A | 15 October 2014 |
| | | | | CN | 104106230 | B | 16 June 2017 |
| | | | | EP | 2755340 | A1 | 16 July 2014 |
| | | | | EP | 2755340 | B1 | 08 May 2019 |
| | | | | JP | 2014-523168 | A | 08 September 2014 |
| | | | | JP | 6089031 | B2 | 01 March 2017 |
| | | | | KR | 10-2014-0050035 | A | 28 April 2014 |
| | | | | US | 2014-0258806 | A1 | 11 September 2014 |
| | | | | US | 9411676 | B2 | 09 August 2016 |
| | | | | WO | 2013-004078 | A1 | 10 January 2013 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 2024009954 W
- KR 1020230091893
- KR 1020230114853

**Non-patent literature cited in the description**

- **S. MYUNG** ; **K. YANG** ; **Y. KIM**. Lifting Methods for Quasi-Cyclic LDPC Codes. *IEEE Communications Letters*, June 2006, vol. 10, 489-491